# EUROPEAN PATENT APPLICATION

(11) **EP 4 485 503 A1**
(43) Date of publication of application: **01.01.2025**
(21) Application number: 23759857.8
(22) Date of filing: 16.02.2023
(51) Int. Cl.: H01L 21/02, H01L 21/304

(54) **SUBSTRATE PROCESSING APPARATUS MANAGEMENT SYSTEM, ASSISTANCE APPARATUS, SUBSTRATE PROCESSING APPARATUS, INTER-CHAMBER PERFORMANCE COMPARISON METHOD, AND INTER-CHAMBER PERFORMANCE COMPARISON PROGRAM**

(30) Priority: 22.02.2022 JP 2022026238; 11.05.2022 JP 2022078485
(71) Applicant: SCREEN Holdings Co., Ltd., Kyoto-shi, Kyoto 602-8585 (JP)
(72) Inventor: NAKANO, Yuta, Kyoto-shi, Kyoto 602-8585 (JP); HORIGUCHI, Hiroshi, Kyoto-shi, Kyoto 602-8585 (JP); SEIWA, Takaaki, Kyoto-shi, Kyoto 602-8585 (JP); MATSUI, Hiroakira, Kyoto-shi, Kyoto 602-8585 (JP); INAGI, Dai, Kyoto-shi, Kyoto 602-8585 (JP); UENO, Tomohiro, Kyoto-shi, Kyoto 602-8585 (JP); YOSHIHARA, Koki, Kyoto-shi, Kyoto 602-8585 (JP); ONO, Takuya, Kyoto-shi, Kyoto 602-8585 (JP)
(74) Representative: Kilian Kilian & Partner mbB
(86) International application number: PCT/JP2023/005509
(87) International publication number: WO 2023/162856

(57) **Abstract**

A substrate processing apparatus management system includes an information analysis device including a model generator that generates a representative model representing correlations in regard to a plurality of processing information pieces representing operations or states relating to a substrate process in a representative chamber among a plurality of chambers, and an assistance device that acquires a plurality of processing information pieces for each of the plurality of chambers, and generates assistance information relating to a maintenance work for another chamber based on comparison information in which correlations in regard to a plurality of processing information pieces for the other chamber are compared with a representative model.

## Description

### [Technical Field]

The present invention relates to a substrate processing apparatus management system, an assistance device, a substrate processing apparatus, a method of comparing performance between chambers and a program of comparing performance between chambers. In particular, the present invention relates to a substrate processing apparatus management system including an assistance device that assists a maintenance work for a substrate processing apparatus including a plurality of chambers for processing substrates and an information analysis device, the assistance device, the substrate processing apparatus including the assistance device, a method of comparing performance between chambers, with the method being executed by the assistance device, and a program of comparing performance between chambers, with the program causing a computer to execute the method of comparing performance between chambers.

### [Background Art]

A substrate processing apparatus includes a plurality of chambers partitioned as spaces for processing substrates such as semiconductor substrates (semiconductor wafers). The plurality of chambers includes constituent elements of the same types to execute processes of the same types on substrates. The plurality of chambers are adjusted such that the same performance is provided by the plurality of chambers.

For example, JP 20196-140496 A discloses a technique for evaluating a unit process by comparing time-series data obtained in the unit process with predetermined reference data. With the technique described in JP 2019-140196 A, it is possible to make adjustment such that the operations of a plurality of constituent elements in each of a plurality of chambers match the reference operations.

[Patent Document 1] JP 2019-140196 A

### [Summary of Invention]

### [Technical Problem]

Although the plurality of chambers are manufactured to provide the same performance, processing results may be different even when the same process is executed on substrates, due to the positions at which the chambers are disposed in a substrate processing apparatus, slight differences in regard to work for installation, individual differences among a plurality of constituent elements that forms each chamber, and the like. However, since being slight, the differences among the plurality of chambers in regard to an operation and a state for a substrate process might not be detected even when the time-series data is compared with the reference data.

An object of the present invention is to provide a substrate processing apparatus management system, an assistance device, a substrate processing apparatus, a method of comparing performance between chambers and a program of comparing performance between chambers, that enable provision of information relating to differences among a plurality of chambers included in the substrate processing apparatus in regard to performance.

### [Solution to Problem]

According to one aspect of the present invention, a substrate processing apparatus management system includes an assistance device that assists a maintenance work for a substrate processing apparatus including a plurality of chambers that process substrates, and an information analysis device, wherein the information analysis device includes a model generator that generates a representative model representing correlations in regard to a plurality of processing information pieces, with each of the plurality of processing information pieces representing an operation or a state relating to a substrate process in a predetermined representative chamber among the plurality of chambers, and the assistance device includes a processing information collector that acquires a plurality of processing information pieces for each of the plurality of chambers, and an assistance information generator that, based on comparison information in which another chamber different from the representative chamber is compared with the representative chamber about correlations in regard to a plurality of processing information pieces, generates assistance information relating to a maintenance work for the another chamber.

According to this aspect, the information analysis device generates the representative model that represents the correlations in regard to a plurality of processing information pieces for the representative chamber, and the assistance device acquires a plurality of processing information pieces for each of the plurality of chambers included in the substrate processing apparatus. Because the representative chamber and another chamber are compared to each other about the correlations in regard to the plurality of processing information pieces, it is possible to detect the differences between the representative chamber and the other chamber about an operation or a state relating to a substrate process. Further, based on the comparison information in which the representative chamber and the other chamber are compared to each other about the correlations in regard to the plurality of processing information pieces, the assistance device generates the assistance information about the maintenance work for the other chamber. Therefore, it is possible to provide the information about the differences between the other chamber and the representative chamber in regard to the performance.

According to another aspect of the present invention, an assistance device that assists a maintenance work for a substrate processing apparatus including a plurality of chambers that process substrates, includes a processing information collector that acquires a plurality of processing information pieces representing operations or states relating to a substrate process in each of the plurality of chambers, and an assistance information generator, based on comparison information in which correlations in regard to the plurality of processing information pieces for a predetermined representative chamber among the plurality of chambers are compared with correlations in regard to the plurality of processing information pieces for another chamber, generates assistance information about a maintenance work for the another chamber.

According to this aspect, the plurality of processing information pieces for each of the plurality of chambers included in the substrate processing apparatus are acquired, and the predetermined representative chamber and the other chamber are compared to each other about the correlations in regard to the plurality of processing information pieces. Therefore, it is possible to detect the differences between the representative chamber and the other chamber in regard to an operation or a state relating to a substrate process. Further, based on the comparison information in which the representative chamber and the other chamber are compared to each other about the correlations in regard to the plurality of processing information pieces, the assistance information about the maintenance work for the other chamber is generated. Therefore, it is possible to provide the information about the differences between the other chamber and the representative chamber in regard to the performance.

Preferably, the comparison information is information obtained when respective correlations in regard to the plurality of processing information pieces are weighted and compared to one another.

According to this aspect, because the correlations in regard to the plurality of processing information pieces representing operations or states relating to a substrate process are weighted, it is possible to detect, at an early state, a difference in regard to an operation or a state that has great influence on performance for a substrate process.

Preferably, the assistance information generator, after executing a duplication process of combining a reference information piece that is predetermined with respect to at least one subject processing information piece among the plurality of processing information pieces, as a new processing information piece, with the plurality of processing information pieces, calculates correlations in regard to a plurality of processing information pieces obtained when the duplication process is executed.

According to this aspect, it is possible to combine the subject processing information piece having no correlation or a slight correlation with another processing information piece, with the reference information piece having a correlation with the other processing information piece. Therefore, in regard to the processing information piece having no correlation or a slight correlation with another processing information piece, it is possible to provide the information about the difference between the representative chamber and the other chamber in regard to the performance.

Preferably, the assistance information generator, after executing a logarithmic operation process on at least one subject processing information piece among the plurality of processing information pieces, calculates correlations in regard to the plurality of processing information pieces.

According to this aspect, because the logarithmic operation process is executed on at least one subject processing information piece among the plurality of processing information pieces, it is possible to improve accuracy of the correlation with another processing information piece in regard to a processing information piece having a small change. Therefore, it is possible to improve the accuracy of the differences between the performance of the representative chamber and the performance of the other chamber.

Preferably, the assistance device further includes a representative chamber determiner that determines one chamber having correlations closest to correlations in regard to averages of the plurality of processing information pieces for each of the plurality of chambers among the plurality of chambers as the representative chamber.

According to this aspect, because a chamber having an average value in regard to an operation or a state relating to a substrate process is determined as a representative chamber from among the plurality of chambers, it is possible to automatically determine the representative chamber.

Preferably, each of the plurality of chambers includes a discharge valve that discharges liquid, and a flow-rate measurer that measures a flow rate of liquid discharged from the discharge valve, and each of the plurality of processing information pieces includes an open signal representing an opening amount input to the discharge valve for control of an opening amount of the discharge valve and a flow rate measured by the flow-rate measurer.

According to this aspect, it is possible to generate the assistance information about the maintenance work for the discharge valve of the other chamber based on the differences between the representative chamber and the other chamber in regard to an open signal and a flow rate.

Preferably, each of the plurality of chambers includes a discharge valve that discharges liquid, and a concentration measurer that measures a concentration of liquid, and each of the plurality of processing information pieces includes an open signal representing an opening amount input to the discharge valve for control of an opening amount of the discharge valve and a concentration measured by the concentration measurer.

According to this aspect, it is possible to generate the assistance information about the maintenance work for another chamber based on the difference between the representative chamber and the other chamber in regard to the correlations for an open signal and a concentration.

Preferably, each of the plurality of chambers includes a concentration measurer that measures a concentration of liquid, and a chamber-temperature measurer that measures a temperature in a chamber, and each of the plurality of processing information pieces includes a concentration measured by the concentration measurer and a temperature measured by the chamber-temperature measurer.

According to this aspect, it is possible to generate the assistance information about the maintenance work for the other chamber based on the differences between the representative chamber and the other chamber in regard to a liquid concentration and a temperature in a chamber.

Each of the plurality of chambers includes a concentration measurer that measures a concentration of liquid, and a liquid-temperature measurer that measures a temperature of liquid, and each of the plurality of processing information pieces includes a concentration measured by the concentration measurer and a temperature measured by the liquid-temperature measurer.

According to this aspect, it is possible to generate the assistance information about the maintenance work for the other chamber based on the differences between the representative chamber and the other chamber in regard to a liquid concentration and a liquid temperature.

Preferably, the assistance device further includes a deviation-degree acquirer that acquires, as the comparison information, deviation-degree information representing respective degrees of deviation between a plurality of respective predicted values that are respectively predicted based on the plurality of processing information pieces for the another chamber using correlations in regard to the plurality of processing information pieces for the representative chamber, and the plurality of respective processing information pieces for the another chamber.

According to this aspect, because a plurality of predicted values are predicted based on the plurality of processing information pieces for the other chamber using the correlations in regard to the plurality of processing information pieces for the representative chamber, it is possible to compare the representative chamber and the other chamber to each other about the correlations in regard to the plurality of processing information pieces. Because the deviation-degree information representing respective degrees of deviation between the plurality of respective predicted values and the plurality of respective processing information pieces for the other chamber is acquired, it is possible to represent the difference between the representative chamber and the other chamber about the correlations in regard to the plurality of processing information pieces.

According to another aspect of the present invention, a substrate processing apparatus includes the above-mentioned assistance device.

According to this aspect, it is possible to provide the substrate processing apparatus that can detect the differences among the plurality of chambers in regard to the performance.

A method of comparing performance between chambers, with the method being executed by an assistance device that assists a maintenance work for a substrate processing apparatus including a plurality of chambers that process substrates, includes the processes of acquiring a plurality of processing information pieces representing operations or states relating to a substrate process in each of the plurality of chambers, and based on comparison information in which correlations in regard to a plurality of processing information pieces for a predetermined representative chamber among the plurality of chambers are compared with correlations in regard to a plurality of processing information pieces for another chamber, generating assistance information relating to a maintenance work for the another chamber.

According to yet another aspect of the present invention, a program of comparing performance between chambers, with the program being executed by a computer included in an assistance device that assists a maintenance work for a substrate processing apparatus including a plurality of chambers that process substrates, and causing the computer to execute the processes of acquiring a plurality of processing information pieces representing operations or states relating to a substrate process in each of the plurality of chambers, and based on comparison information in which correlations in regard to a plurality of processing information pieces for a predetermined representative chamber among the plurality of chambers are compared with correlations in regard to a plurality of processing information pieces for another chamber, generating assistance information relating to a maintenance work for the another chamber.

### [Advantageous Effects of Invention]

With the present invention, it is possible to provide the information about the differences among a plurality of chambers included in the substrate processing apparatus, with the differences being about the performance.

### [Brief Description of the Drawings]

[FIG. 1] Fig. 1 is a diagram for explaining the overall configuration of a substrate processing apparatus management system according to one embodiment of the present invention.
[FIG. 2] Fig. 2 is a conceptual diagram for explaining an operation of the substrate processing apparatus management system.
[FIG. 3] Fig. 3 is a diagram for explaining the specific example of calculation of deviation degrees.
[FIG. 4] Fig. 4 is a diagram showing one example of a deviation-degree table.
[FIG. 5] Fig. 5 is a block diagram for explaining one example of the functional configurations of the substrate processing apparatus management system.
[FIG. 6] Fig. 6 is a flowchart showing one example of a flow of a processing information transmission process.
[FIG. 7] Fig. 7 is a flowchart showing one example of a flow of a model generation process.
[FIG. 8] Fig. 8 is a flowchart showing one example of a flow of a process of comparing performance between chambers.
[FIG. 9] Fig. 9 is a diagram showing one example of a weighting table.
[FIG. 10] Fig. 10 is a block diagram for explaining one example of the functional configurations of a substrate processing apparatus management system in a second modified example.
[FIG. 11] Fig. 11 is a flowchart showing one example of a flow of a representative chamber determination process.
[FIG. 12] Fig. 12 is a block diagram for explaining one example of the functional configurations of a substrate processing apparatus management system in a third modified example.
[FIG. 13] Fig. 13 is a diagram showing one example of a deviation-degree table in the third modified example.
[FIG. 14] Fig. 14 is a flowchart showing one example of a flow of a model generation process in the third modified example.
[FIG. 15] Fig. 15 is a flowchart showing one example of a flow of a process of comparing performance between chambers in the third modified example.

### [Description of Embodiments]

An assistance device, a method of comparing performance between chambers and a program of comparing performance between chambers according to one embodiment of the present invention will be described below with reference to the drawings. In the following description, a substrate refers to a semiconductor substrate, a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like. In the following description, a person who manages a substrate processing apparatus is referred to as an administrator and a person who performs the maintenance work for the substrate processing apparatus is referred to as a maintenance worker.

### 1. Overall Configuration of Substrate Processing Apparatus Management System

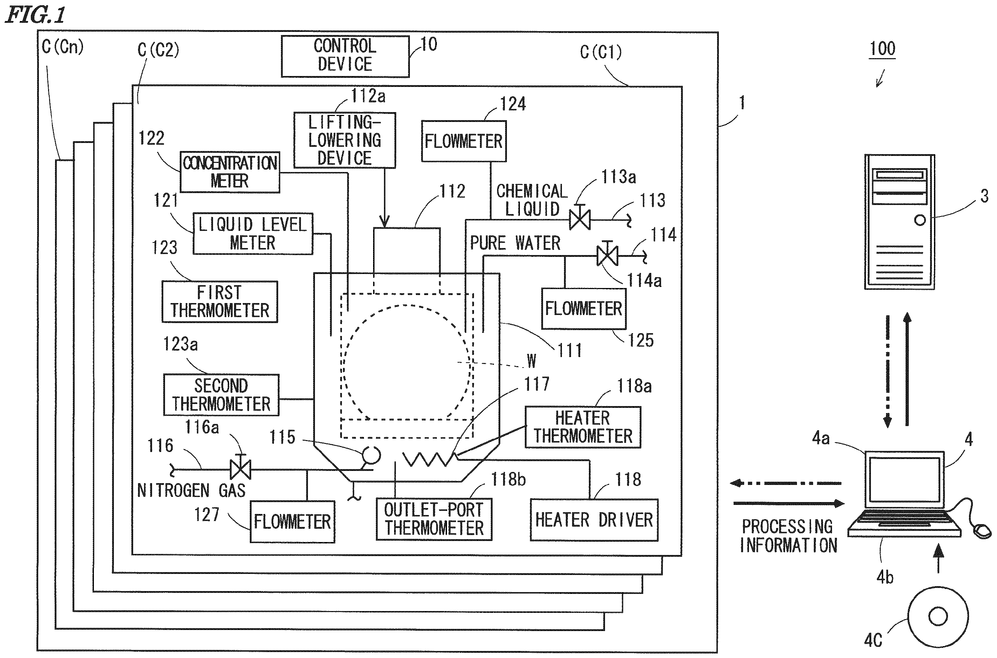

First, the overall configuration of a substrate processing apparatus management system including the assistance device according to the present embodiment will be described. Fig. 1 is a diagram for explaining the overall configuration of the substrate processing apparatus management system according to the one embodiment of the present invention. As shown in Fig. 1, the substrate processing apparatus management system 100 includes the substrate processing apparatus 1, an information analysis device 3 and the assistance device 4. The information analysis device 3 is a server, for example, and includes a CPU (Central Processing Unit) and a memory. The assistance device 4 is a personal computer, for example, and includes a CPU and a memory. A CD-ROM (Compact Disc Read Only Memory) 4c, which is a computer-readable recording media, is attachable to and detachable from the assistance device 4, and the assistance device 4 can read and execute a program recorded in the CD-ROM 4c.

The information analysis device 3 and the assistance device 4 are used to manage the substrate processing apparatus 1. The number of substrate processing apparatuses 1 managed by the information analysis device 3 and the assistance device 4 is not limited to one, and a plurality of substrate processing apparatuses 1 may be managed.

The assistance device 4 according to the present embodiment is used to assist the maintenance work for the substrate processing apparatus 1 performed by the maintenance worker. The assistance device 4 is connected to each of the substrate processing apparatus 1 and the information analysis device 3 by a wired communication line or a wireless communication network. For example, the assistance device 4 is connected to each of the substrate processing apparatus 1 and the information analysis device 3 by a communication network such as the Internet or a Local Area Network. In the present embodiment, the assistance device 4 is connected to each of the substrate processing apparatus 1 and the information analysis device 3, wired or wireless.

### 2. One Example of Configuration of Substrate Processing Apparatus 1

As shown in Fig. 1, the substrate processing apparatus 1 is a batch-type substrate cleaning device, and includes a control device 10 and a plurality of chambers C1 to Cn. Here, n is a positive integer. A chamber is a space that is partitioned to process a substrate. Although the number of chambers C1 to Cn is not limited, n = 12 here, by way of example. In the substrate processing apparatus 1, a display device, a speech output device and an operation unit (not shown) are provided in addition to the plurality of chambers C1 to Cn.

Each of the plurality of chambers C1 to Cn includes a plurality of constituent elements of similar types. Here, the chamber C1 will be described as an example. The chamber C1 includes a processing tank 111, a substrate holder 112, a lifting-lowering device 112a, a bubbler pipe 115, a heater 117 and a heater driver 118.

The substrate holder 112 is configured to be capable of holding a plurality of substrates W. The processing tank 111 is configured to be capable of accommodating the plurality of substrates Wheld by the substrate holder 112. A cleaning liquid for cleaning the substrate W is stored in the processing tank 111.

The lifting-lowering device 112a supports the substrate holder 112 to be movable in an upward-and-downward direction and moves the substrate holder 112 in the upward-and-downward direction with the control of the control device 10. Thus, the lifting-lowering device 112a can immerse the plurality of substrates W held by the substrate holder 112 in the cleaning liquid stored in the processing tank 111, and can pull up the plurality of substrates W immersed in the cleaning liquid from the processing tank 111. The plurality of substrates W are cleaned by being immersed in the cleaning liquid. Further, in the lifting-lowering device 112a, a motor (not shown) as a power source for moving the substrate holder 112 in the upward-and-downward direction is provided.

A chemical liquid pipe 113 and a pure water pipe 114 are connected to the processing tank 111. A chemical liquid valve 113a and a flowmeter 124 are provided in the chemical liquid pipe 113. The chemical liquid valve 113a is a control valve the opening (degree of opening) of which is adjustable by the control of the control device 10.

The chemical liquid pipe 113 guides a chemical liquid supplied from a chemical liquid supply system (not shown) to the processing tank 111 when the chemical liquid valve 113a is opened. The flow rate (supply amount per unit time) of the chemical liquid supplied to the processing tank 111 through the chemical liquid pipe 113 changes in accordance with an opening (degree of opening) of the chemical liquid valve 113a. As the chemical liquid, BHF (Buffered Hydrofluoric Acid), DHF (Dilute Hydrofluoric Acid), hydrofluoric acid, hydrochloric acid, sulfuric acid, nitric acid, phosphoric acid, acetic acid, oxalic acid, ammonia, or the like is used. The flowmeter 124 detects the flow rate of the chemical liquid in the portion farther downstream than the chemical liquid valve 113a in the chemical liquid pipe 113, and provides a detection result to the control device 10.

A pure water valve 114a and a flowmeter 125 are provided in the pure water pipe 114. The pure water valve 114a is a control valve the opening of which is adjustable by the control of the control device 10. The pure water pipe 114 guides a pure water supplied from a pure water supply system (not shown) to the processing tank 111 when the pure water valve 114a is opened. The flow rate (supply amount per unit time) of the pure water supplied to the processing tank 111 through the pure water pipe 114 changes in accordance with an opening (degree of opening) of the pure water valve 114a. The flowmeter 125 detects the flow rate of the pure water in the portion farther downstream than the pure water valve 114a in the pure water pipe 114, and provides a detection result to the control device 10.

The bubbler pipe 115 is fixed to a portion inside of the processing tank 111 and in the vicinity of the lower end portion of the processing tank 111 by a bubbler fixture (not shown). A gas pipe 116 is connected to the bubbler pipe 115. In the gas pipe 116, a gas valve 116a and a flowmeter 127 are provided. The gas valve 116a is a control valve the opening of which is adjustable by the control of the control device 10.

The gas pipe 116 guides a nitrogen gas supplied from a gas supply system (not shown) to the bubbler pipe 115 in the processing tank 111 when the gas valve 116a is opened. The flow rate (supply amount per unit time) of the nitrogen gas supplied to the bubbler pipe 115 through the gas pipe 116 changes in accordance with an opening (degree of opening) of the gas valve 116a. The flowmeter 127 detects the flow rate of the nitrogen gas in the portion farther downstream than the gas valve 116a in the gas pipe 116, and provides a detection result to the control device 10. In this case, the control device 10 adjusts the opening of the gas valve 116a based on the flow rate provided by the flowmeter 127 such that the nitrogen gas is supplied to the bubbler pipe 115 at a predetermined flow rate.

The openings of the chemical liquid valve 113a and the pure water valve 114a are adjusted, so that the chemical liquid and the pure water are supplied into the processing tank 111 at a predetermined ratio. In this state, the gas valve 116a is further opened. Thus, the nitrogen gas is supplied to the bubbler pipe 115, and a large amount of bubbles are generated in the bubbler pipe 115. The generated bubbles are lifted in the processing tank 111. Therefore, the chemical liquid and the pure water supplied into the processing tank 111 are mixed, and the cleaning liquid is generated. Instead of a nitrogen gas, another inert gas such as an argon gas may be supplied to the bubbler pipe 115.

The heater 117 is further provided in a portion inside of the processing tank 111 and in the vicinity of the lower end portion of the processing tank 111. The heater 117 has a path through which the cleaning liquid passes, and the cleaning liquid is heated by the heater 117 while passing through the path. The heater driver 118 drives the heater 117 by supplying electric power to the heater 117. A heater thermometer 118a detects the surface temperature of the heater 117 and provides the detection result to the control device 10. An outlet-port thermometer 118b is provided near the outlet port of the path of the heater 117, detects the temperature of the cleaning liquid immediately after being heated by the heater 117, and provides the detection result to the control device 10. The control device 10 determines an amount of power to be supplied to the heater 117 based on a surface temperature provided from the heater thermometer 118a and a temperature of the cleaning liquid provided from the outlet-port thermometer 118b, and controls the heater driver 118.

Further, a drain pipe is connected to a bottom portion of the processing tank 111. A valve (not shown) is provided in the drain pipe. The valve provided in the drain pipe is opened, so that the cleaning liquid in the processing tank 111 is discharged to the outside of the chamber C1.

In the processing tank 111, a liquid level meter 121, a concentration meter 122, a first thermometer 123 and a second thermometer 123a, as a plurality of detectors for detecting the state of the cleaning liquid stored in the processing tank 111, are provided.

The liquid level meter 121 detects the height of liquid surface (liquid level) of the cleaning liquid stored in the processing tank 111 and provides the detection result to the control device 10. The concentration meter 122 detects the concentration of the cleaning liquid (chemical concentration) stored in the processing tank 111 and provides the detection result to the control device 10. The first thermometer 123 is arranged in the chamber C1 and outside of the processing tank 111, detects the temperature in the chamber C1, and provides the detection result to the control device 10. The second thermometer 123a is provided inside of the processing tank 111, detects the temperature of the cleaning liquid accumulated in the processing tank 111, and provides the detection result to the control device 10.

The control device 10 includes a CPU (Central Processing Unit) and a memory, for example, and controls an operation of the lifting-lowering device 112a, an operation of the heater driver 118, openings of the chemical liquid valve 113a, the pure water valve 114a and the gas valve 116a, and the like. The memory of the control device 10 stores a program for execution of a cleaning process for the substrate W by the substrate processing apparatus 1.

Further, based on the detection results of the flowmeters 124, 125, the detection result of the liquid level meter 121 and the detection result of the concentration meter 122, the control device 10 adjusts the openings of the chemical liquid valve 113a, the pure water valve 114a, the gas valve 116a and the valve of the drain pipe (not shown). Thus, in a state in which the cleaning liquid having a predetermined chemical concentration is stored in the processing tank 111, the liquid level of the cleaning liquid is maintained at a predetermined height. Further, based on the detection result of the chemical concentration provided by the concentration meter 122, the control device 10 performs feedback control of an amount of the chemical liquid to be supplied to the processing tank 111 such that the chemical concentration of the cleaning liquid stored in the processing tank 111 is within a predetermined range. For example, in a case in which the chemical concentration of the cleaning liquid detected by the concentration meter 122 is lower than a predetermined range, the control device 10 controls the chemical liquid valve 113a to supply an additional chemical liquid from the chemical liquid supply system (not shown) to the processing tank 111 through the chemical liquid pipe 113.

Further, based on the temperatures provided by the first thermometer 123, the second thermometer 123a, the heater thermometer 118a and the outlet-port thermometer 118b, the control device 10 controls the heater driver 118 such that the cleaning liquid stored in the processing tank 111 is maintained at a predetermined temperature.

### 3. Processing Information

In each of the plurality of chambers C1 to Cn included in the substrate processing apparatus 1, the information pieces representing operations or states relating to a process for the substrate W are defined. As indicated by the thick solid arrow in Fig. 1, these processing information pieces are transmitted from the control device 10 of the substrate processing apparatus 1 to the assistance device 4 in a predetermined cycle. The processing information pieces may be transmitted from the control device 10 to the assistance device 4 in real time. The processing information pieces may be transmitted from the control device 10 to a computer different from the assistance device 4 and may be transmitted from the computer to the assistance device 4.

The processing information pieces transmitted from the control device 10 of the substrate processing apparatus 1 to the assistance device 4 include "a. CHEMICAL CONCENTRATION," "b. FLOW RATE OF CHEMICAL LIQUID," "c. TEMPERATURE IN CHAMBER," "d. TEMPERATURE OF CHEMICAL LIQUID," "e. TEMPERATURE AT HEATER OUTLET PORT," "f. SURFACE TEMPERATURE OF HEATER," "g. INPUT AMOUNT OF CONCENTRATION FB," "h. OPENING OF INPUT VALVE" and "i. HEATER ON SIGNAL."

"a. CHEMICAL CONCENTRATION" indicates the chemical concentration of a cleaning liquid in the processing tank 111 detected by the concentration meter 122. "b. FLOW RATE OF CHEMICAL LIQUID" indicates the flow rate of a chemical liquid flowing through the chemical liquid pipe 113 detected by the flowmeter 124. "e. TEMPERATURE OF CHEMICAL LIQUID" indicates the temperature in a chamber detected by the first thermometer 123. "d. TEMPERATURE OF CLEANING LIQUID" indicates the temperature of a cleaning liquid accumulated in the processing tank 111 detected by the second thermometer 123a. "e. TEMPERATURE AT HEATER OUTPUT PORT" indicates the temperature of a chemical liquid near the outlet port of the cover of the heater 117 detected by the outlet-port thermometer 118b. "f. HEATER SURFACE TEMPERATURE" indicates the temperature of the surface of the heater 117 detected by the heater thermometer 118a. "g. INPUT AMOUNT OF CONCENTRATION FB" is a value calculated by the control device 10 based on the flow rate detected by the flowmeter 124, and indicates an amount of the chemical liquid input from the chemical liquid pipe 113 to the processing tank 111 such that the chemical concentration of the cleaning liquid stored in the processing tank 111 is within a predetermined range. "b. OPENING OF INPUT VALVE" indicates the opening of the chemical liquid valve 113a provided in the chemical liquid pipe 113. "i. HEATER ON SIGNAL" is a signal output by the heater driver 118 for control of the heater 117.

### 4. Operation of Detecting Difference Between Chambers

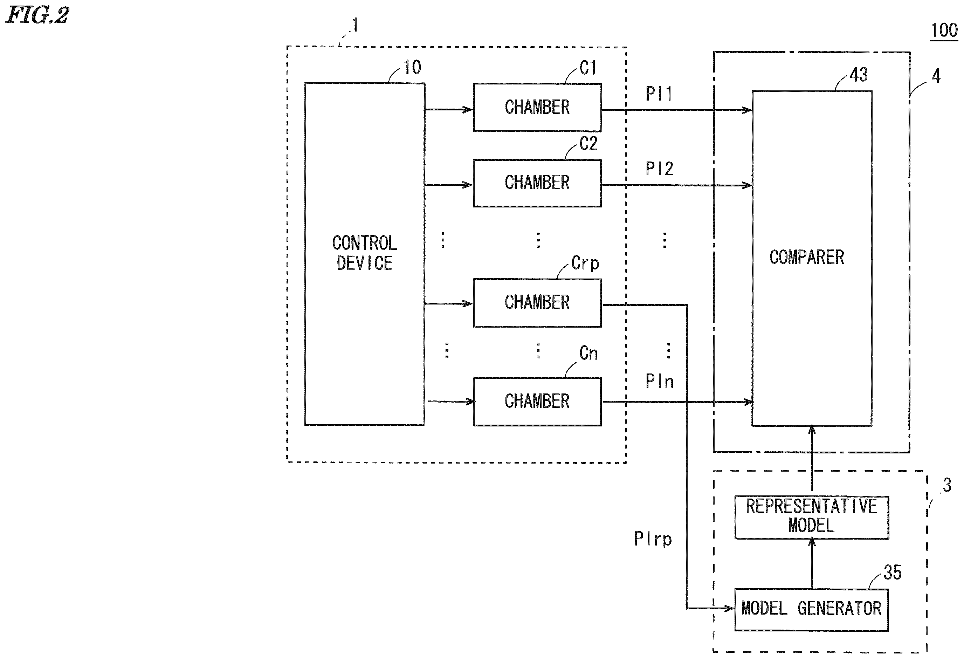

Fig. 2 is a conceptual diagram for explaining an operation of the substrate processing apparatus management system. With reference to Fig. 2, in the substrate processing apparatus management system 100 in the present embodiment, a representative chamber Crp is predetermined from among the plurality of chambers C1 to Cn included in the substrate processing apparatus 1. In the substrate processing apparatus management system 100, the correlations in regard to a plurality of processing information pieces for each of the plurality of chambers C1 to Cn included in the substrate processing apparatus 1 are compared with the correlations in regard to a plurality of processing information pieces for the representative chamber Crp, and the operation and state relating to a substrate process in each of the plurality of chambers C1 to Cn are determined based on the comparison result. In Fig. 2, PI1 to Pln represent processing information pieces respectively corresponding to the plurality of chambers C1 to Cn.

The information analysis device 3 generates a model corresponding to the representative chamber Crp by executing machine learning using processing information pieces Plrp corresponding to the representative chamber Crp. Here, the model corresponding to the representative chamber Crp produced by the information analysis device 3 is referred to as a representative model. Specifically, the information analysis device 3 defines a plurality of combinations each of which includes two different processing information pieces using the processing information pieces Plrp, and derives the correlation between the two processing information pieces forming each combination as an invariant relationship. For example, the correlation between two processing information pieces is expressed by a function in which one processing information piece takes the other processing information piece as a variable and a function in which the other processing information piece takes the one processing information piece as a variable. The invariant relationship derived by the information analysis device 3 when the information analysis device 3 executes machine learning on the plurality of processing information pieces Plrp is a representative model.

Using the processing information pieces PI1 to Pin respectively corresponding to the plurality of chambers C1 to Cn, for each of the plurality of chambers C1 to Cn, the assistance device 4 compares the correlation between two processing information pieces forming each combination with the invariant relationship defined by the representative model in regard to each of a plurality of combinations each of which includes two different information pieces. The assistance device 4 compares each of the plurality of chambers C1 to Cn with the representative model. Here, the chamber C1 is compared with the representative model, by way of example. Using the processing information pieces PI1 corresponding to the chamber C1, the assistance device 4 compares the correlation between two different processing information pieces included in each of a plurality of combinations with the invariant relationship defined by the representative model. Specifically, the assistance device 4 calculates degrees of deviation from the representative model as deviation degrees by using the processing information pieces PI1 corresponding to the chamber C1. Further, based on the calculated deviation degrees, the assistance device 4 calculates a degree of abnormality of the chamber C1 as an abnormality score. That is, in a case in which the abnormality score is low, it indicates that the operation of the chamber C1 is similar to the operation of the representative chamber Crp, and the chamber C1 is operating normally. In a case in which the abnormality score is high, it indicates that the operation of the chamber C1 is different from the operation of the representative chamber Crp. In a case in which the operation of the chamber C1 is different from the operation of the representative chamber Crp, the operation of the chamber C1 is highly likely abnormal.

### <Example of Calculation of Abnormality Score>

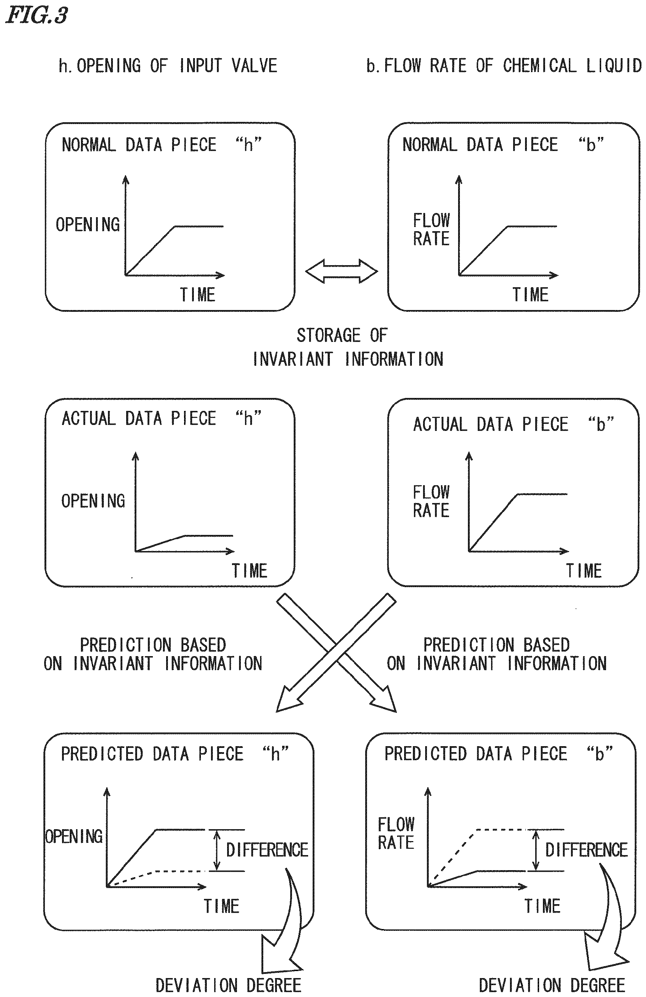

Next, a specific example of a method of calculating an abnormality score will be described. The representative model defines the correlation between two different processing information pieces included in each of a plurality of combinations. In order to calculate the abnormality score of the chamber C1, the deviation degrees of the processing information pieces PL1 corresponding to the chamber C1 are calculated. Fig. 3 is a diagram for explaining the specific example of calculation of a deviation degree. Here, the example of calculation of the deviation degree corresponding to the combination of "h. OPENING OF INPUT VALVE" and "b. FLOW RATE OF CHEMICAL LIQUID" of Fig. 1 is described. In the following description, the data of "b. OPENING OF INPUT VALVE" is suitably referred to as a data piece "h," and the data of "f. FLOW RATE OF CHEMICAL LIQUID" is suitably referred to as a data piece "d."

In order to calculate a deviation degree, the reference data representing the invariant relationship between "b. OPENING OF INPUT VALVE" and "f. FLOW RATE OF CHEMICAL LIQUID" is required. As such, the assistance device 4 stores the representative model generated by the information analysis device 3 before a process is actually executed on the substrate W in the substrate processing apparatus 1. The representative model defines the correlation between the data piece "h" and the data piece "b" when the representative chamber Crp is normally operating in accordance with a predetermined processing recipe.

The representative model is generated by the information analysis device 3 based on the processing information pieces Plrp corresponding to the representative chamber Crp selected from among the plurality of chambers C1 to Cn when the substrate processing apparatus 1 is actually operating normally, for example.

In the upper portion of Fig. 3, one example of the temporal changes of the data piece "h" and the ideal data piece "b" for the representative model is shown by the graphs. In the graph for the data piece "h," the abscissa indicates time, and the ordinate indicates an opening of the chemical liquid valve 113a provided in the chemical liquid pipe 113. In the graph for the data piece "b," the abscissa indicates time, and the ordinate indicates a flow rate of a chemical liquid flowing through the chemical liquid pipe 113 detected by the flowmeter 124. The abscissa (time axis) is common between the graph for the data piece "h" and the graph for the data piece "b."

According to the two graphs in the upper portion of Fig. 3, it is found that the flow rate of the chemical liquid flowing through the chemical liquid pipe 113 detected by the flowmeter 124 increases at a substantially constant rate as a value for the opening of the chemical liquid valve 113a increases. That is, the opening of the chemical liquid valve 113a and the value for the flow rate of the chemical liquid flowing through the chemical liquid pipe 113 have a correlation. In a case in which the representative chamber Crp operates normally, the correlation for each combination in regard to the plurality of processing information pieces is equal to the correlation defined by the representative model.

In this state, in the chamber C1, the process is executed on the substrate W, and an actual data piece "h" and an actual data piece "b" are collected by the assistance device 4. In the center portion of Fig. 3, one example of the temporal changes of the data piece "h" and the data piece "b" for the chamber C1 is shown.

The correlation between the data piece "h" and the data piece "b" for the chamber C1 is compared with the correlation between the data piece "h" and the data piece "b" for the representative chamber Crp. Specifically, with reference to the representative model, the data piece "b" is predicted based on the data piece "h" for the chamber C1. In other words, with reference to the correlation of the data piece "b" with the data piece "h" defined for the representative model, the data piece "b" is predicted based on the data piece "h" for the chamber C1. Further, with reference to the representative model, the data piece "h" is predicted based on the data piece "b" for the representative model. In other words, with reference to the correlation of the data piece "h" with the data piece "b" defined for the representative model, the data piece "h" is predicted based on the data piece "b" for the chamber C1.

In the lower portion of Fig. 3, one example of the temporal changes of the data piece "h" and the ideal data piece "b" that are predicted based on the representative model is shown in the graphs. In the graph in the lower portion of Fig. 3, the predicted data piece "h" and the predicted data piece "b" are indicated by the solid lines, and the data piece "h" and the data piece "b" for the chamber C1 are indicated by the dotted lines.

In a case in which the chamber C1 is performing the same operation as that of the representative chamber Crp, the data piece "h" for the chamber C1 and the data piece "h" predicted based on the data piece "b" coincide or substantially coincide with each other. Further, the data piece "b" for the chamber C1 and the data piece "b" predicted based on the data piece "h" coincide or substantially coincide with each other. However, in a case in which the chamber C1 operates differently from the representative chamber Crp, the data piece "h" for the chamber C1 and the predicted data piece "h" are highly likely to deviate from each other. Further, the data piece "b" for the chamber C1 and the predicted data piece "b" are likely to deviate from each other. It is considered that, the larger a degree of difference between the operation of the chamber C1 and the operation of the representative chamber Crp, the larger a degree of deviation. Further, the smaller a degree of difference between the operation of the chamber C1 and the operation of the representative chamber Crp, the smaller a degree of deviation.

As such, in the present embodiment, in regard to each of the processing information pieces PI1 corresponding to the chamber C1, the value of difference from the predicted value that is predicted based on the representative model is calculated as a deviation degree. In the example of Fig. 3, when calculating a deviation degree at a certain point in time, the assistance device 4 calculates the difference value between the data piece "h" for the chamber C1 and the predicted data piece "h" as a deviation degree. Further, the assistance device 4 calculates the difference value between the data piece "b" for the chamber C1 and the predicted data piece "b" as a deviation degree.

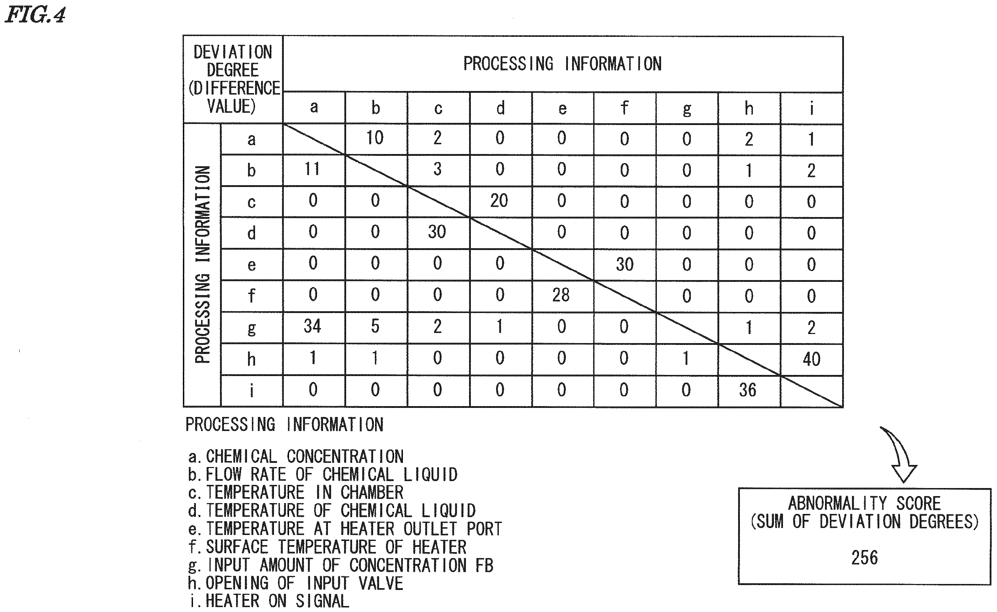

Fig. 4 is a diagram showing one example of a deviation-degree table. The deviation-degree table is the table representing the deviation degree for each of all combinations in regard to the processing information pieces. The assistance device 4 calculates the above-mentioned deviation degrees for all combinations in regard to the processing information pieces. With reference to Fig. 4, each of the plurality of values arranged in the row at the right of each of the processing information pieces "a" to "i" in the left column of the deviation-degree table represents the deviation degree between the processing information piece predicted based on each of the processing information pieces "a" to "i" in the upper row, and an actually acquired processing information piece. Each of the plurality of values arranged in the column below each of the processing information pieces "a" to "i" in the upper row of the deviation-degree table represents the deviation degree between the processing information piece predicted based on each of the processing information pieces "a" to "i" in the left column, and an actually acquired processing information piece.

For example, the value "10" at the intersection of the row for the processing information piece "a" in the left column and the column for the processing information piece "b" in the upper row represents the deviation degree between the processing information piece "a" that is predicted based on the processing information piece "b" and the processing information piece "a" corresponding to the chamber C1. Further, the value "11" at the intersection of the row for the processing information piece "b" in the left column and the column for the processing information piece "a" in the upper row represents the deviation degree between the predicted value for the processing information piece "b" that is predicted based on the processing information piece "a" and the processing information piece "b" corresponding to the chamber C1.

The deviation-degree table shown in Fig. 4 shows the plurality of deviation degrees calculated for all of combinations in regard to the processing information pieces relating to the chamber C1. When all of the deviation degrees are calculated, the assistance device 4 calculates the sum of the plurality of calculated deviation degrees as the abnormality score corresponding to the chamber C1. In the deviation-degree table shown in Fig. 4, the abnormality score is 256.

### 5. One Example of Functional Configuration of Assistance Device 4

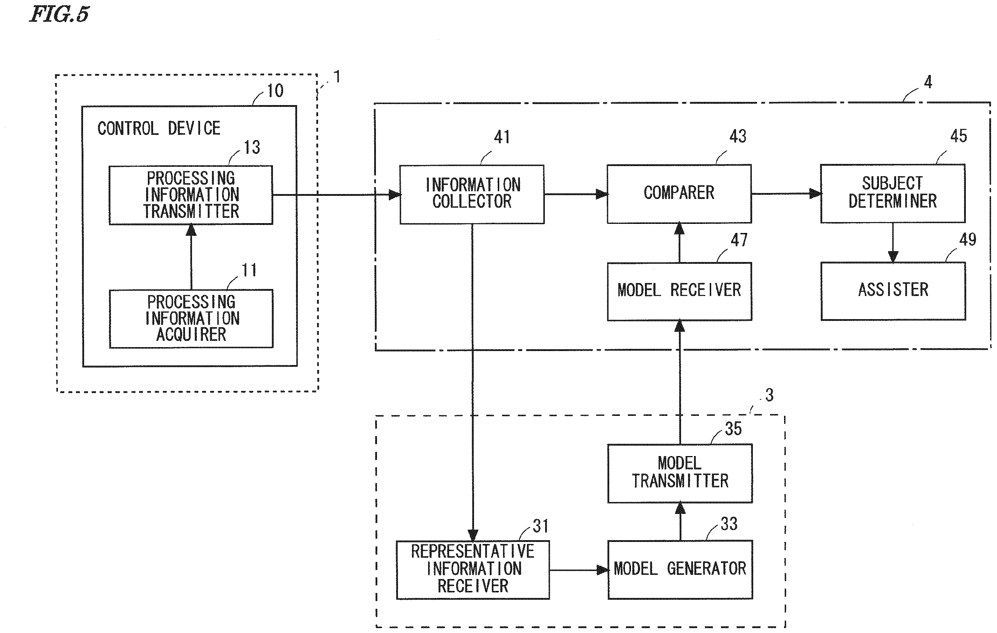

Fig. 5 is a block diagram for explaining one example of the functional configurations of the substrate processing apparatus management system. With reference to Fig. 5, the control device 10 included in the substrate processing apparatus 1 includes a processing information acquirer 11 and a processing information transmitter 13. The functions of the control device 10 are implemented when the CPU included in the control device executes a control program stored in the memory.

The processing information acquirer 11 acquires the respective processing information pieces PI1 to Pln from the plurality of respective chambers C1 to Cn. Here, the processing information pieces PI1 are acquired from the chamber C1, by way of example. The processing information acquirer 11 acquires the processing information pieces PI1 from the chamber C1 at predetermined time intervals. Therefore, the plurality of processing information pieces PI1 are time-series data pieces in which values are defined for each of points in time that are defined according to the predetermined time intervals. The processing information transmitter 13 transmits the processing information pieces PI1 to Pln respectively acquired from the chambers C1 to Cn to the assistance device 4. Since the chambers C1 to Cn process substrates in accordance with processing recipes, the processing information pieces PI1 to Pln may be time-series data pieces that are collected in a period during which the chambers C1 to Cn process the substrates in accordance with the processing recipes.

The assistance device 4 includes an information collector 41, a comparer 43, a subject determiner 45, a model receiver 47 and an assister 49. The functions of the assistance device 4 are implemented when the CPU included in the assistance device 4 executes an assistance information generation program stored in the memory.

The information collector 41 collects the processing information pieces PI1 to Pin representing operations and states in regard to a substrate process executed in each of the plurality of chambers C1 to Cn. The information collector 41 receives the plurality of processing information pieces PI1 to Pin from the control device 10, outputs the plurality of received processing information pieces PI1 to Pin to the comparer 43, and transmits the plurality of received processing information pieces PI1 to Pin to the information analysis device 3.

The model receiver 47 receives a representative model from the information analysis device 3 and outputs the received representative model to the comparer 43. The representative model defines the correlations in regard to the processing information pieces Plrp corresponding to the representative chamber Crp.

The comparer 43 compares the correlations in regard to each of the processing information pieces PI1 to Pin corresponding to each of the plurality of chambers C1 to Cn with the correlations in regard to the representative model, and outputs the comparison results to the subject determiner 45. The processing information pieces PI1 corresponding to the chamber C1 will be described, for example. The processing information pieces PI include a plurality of data pieces "a" to "i." The comparer 43 calculates the predicted values respectively corresponding to the data pieces "a" to "i" of the processing information pieces PI1 using the representative model, and calculates the respective differences between the respective data pieces "a" to "i" and the respective predicted values as deviation degrees. Further, the comparer 43 calculates the sum of the plurality of deviation degrees calculated for the processing information pieces PI1 as an abnormality score.

The subject determiner 45 determines a chamber to be maintained based on the abnormality score calculated by the comparer 43. For example, the subject determiner 45 compares the abnormality score with a predetermined threshold value in regard to each of the plurality of chambers C1 to Cn. The subject determiner 45 determines a chamber having an abnormality score equal to or larger than the predetermined threshold value among the plurality of chambers C1 to Cn as a chamber to be maintained.

The assister 49 generates assistance information relating to the maintenance work for the chamber determined as a maintenance subject by the subject determiner 45. Here, the chamber C1 is determined as a maintenance subject, by way of example. The assister 49 notifies the maintenance worker of chamber identification information, as the assistance information, for identifying the chamber C1 determined as a maintenance subject. Thus, the maintenance worker is notified that the chamber C1 needs to be maintained.

Further, the assister 49 displays the plurality of deviation degrees calculated by the comparer 43 for the processing information pieces PI1 relating to the chamber C1 as the assistance information. For example, the maintenance worker is notified of the deviation-degree table shown in Fig. 4 as the assistance information. Thus, the maintenance worker can be notified of the information for determining constituent elements that need adjustment among a plurality of constituent elements of the chamber C1.

In order to notify the maintenance worker of the assistance information, the assister 49 may display the assistance information on a display included in the assistance device 4 or may transmit an electronic mail including the assistance information to the maintenance worker.

Based on the deviation-degree table shown in Fig. 4, the deviation in regard to the chemical concentration can be recognized based on the deviation degrees in the row and column for the "a. CHEMICAL CONCENTRATION," for example. Further, the deviation in regard to the temperature of chemical liquid can be recognized based on the deviation degrees in the row and column for "d. TEMPERATURE OF CHEMICAL LIQUID." Further, it is possible to recognize whether an increase in temperature is stable based on the deviation degrees in the rows and columns for "e. TEMPERATURE AT HEATER OUTLET PORT" and "f. SURFACE TEMPERATURE OF HEATER." Further, it is possible to recognize whether the feedback control for the chemical concentration is stable based on the deviation degrees in the row and the column for "g. INPUT AMOUNT OF CONCENTRATION FB." Further, it is possible to recognize whether an increase in flow rate of a chemical liquid is stable based on the deviation degrees in the rows and columns for "b. FLOW RATE OF CHEMICAL LIQUID" and "f. OPENING OF INPUT VALVE." Further, the delay in point in time at which heater control is executed is recognized based on the deviation degrees in the column and row for "i. HEATER ON SIGNAL."

The information analysis device 3 includes a representative information receiver 31, a model generator 33 and a model transmitter 35. The functions of the information analysis device 3 are implemented when the CPU included in the information analysis device 3 executes a model generation program stored in the memory.

The representative information receiver 31 receives the plurality of processing information pieces Plrp corresponding to the representative chamber Crp. The representative chamber Crp is a chamber selected from among the plurality of chambers C1 to Cn. The representative chamber Crp is selected by the administrator who manages the substrate processing apparatus 1 or the maintenance worker. For example, the substrate processing apparatus 1 is driven to execute a process on the substrates W, and the inspection result of each substrate W after the substrate W is processed by each of the chambers C1 to Cn is stored as a processing result in association with the chamber. With reference to the processing results, the administrator or the maintenance worker can select a chamber having the best processing result as a representative chamber from among the plurality of chambers C1 to Cn. The processing information pieces Plrp received by the representative information receiver 31 are the processing information pieces corresponding to the processing result to which the maintenance worker has referred to select the representative chamber Crp.

The model generator 33 generates a representative model by executing machine learning on the processing information pieces Plrp corresponding to the representative chamber Crp. Specifically, the processing information pieces PI includes a plurality of data pieces "a" to "i." The model generator 33 learns the correlation for each set including two different data pieces among a plurality of data pieces included in the processing information pieces Plrp. The model generator 33 outputs the generated representative model to the model transmitter 35. The model transmitter 35 transmits the representative model to the assistance device 4.

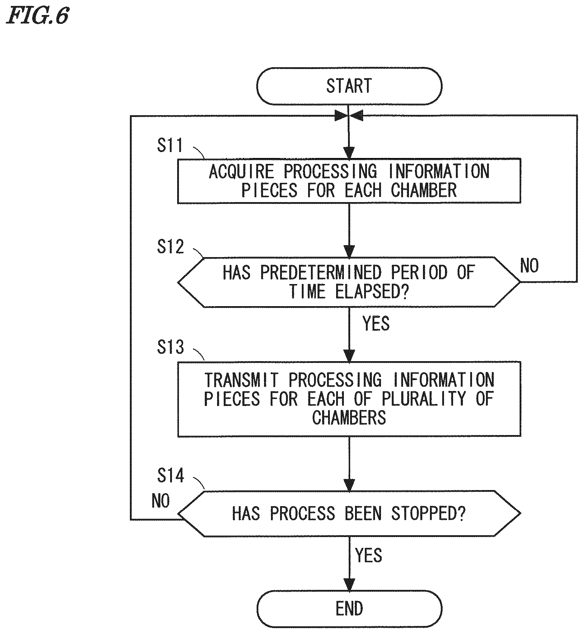

Fig. 6 is a flowchart showing one example of a flow of a processing information transmission process. The processing information transmission process is a process executed by the CPU included in the control device 10 of the substrate processing apparatus 1 when the CPU executes a processing information transmission program stored in the memory. With reference to Fig. 6, the control device 10 acquires the processing information pieces for each of the plurality of chambers C1 to Cn (step S11). The control device 10 acquires the processing information pieces PI1 from the chamber C1 in a predetermined cycle, for example.

In the next step S12, whether a predetermined period of time has elapsed is determined. The predetermined period of time may be a period of time during which the chamber C1 processes one substrate according to a processing recipe, for example. If the predetermined period of time has elapsed, the process proceeds to the step S13. If not, the process returns to the step S11. The step S11 and the step S12 are executed for each of the plurality of chambers C1 to Cn. Therefore, the processing information pieces PI1 to Pin respectively corresponding to the plurality of chambers C1 to Cn are acquired. In a case in which a predetermined cycle is repeated multiple times in a predetermined period of time, the number of groups each of which includes the processing information pieces PI1 corresponds to the number of repetitions of the predetermined cycle.

In the step S13, the processing information pieces PI1 to PIn respectively corresponding to the plurality of chambers C1 to Cn are transmitted to the assistance device 4, and the process proceeds to the step S14. In the step S14, whether the process executed by the substrate processing apparatus 1 has been stopped is determined. If the process is stopped, the process ends. If not, the process returns to the step S11. Therefore, in a period during which the substrate processing apparatus 1 executes the process, the processing information pieces PI1 to PIn respectively corresponding to the plurality of chambers C1 to Cn are transmitted to the assistance device 4. Instead of transmission of the processing information pieces PI1 to PIn each time the predetermined period of time elapses, after a period longer than the predetermined period of time has elapsed, such as a point in time designated by the administrator of the substrate processing apparatus 1, the control device 10 may collectively transmit the processing information pieces PI1 to Pin that have been collected till then.

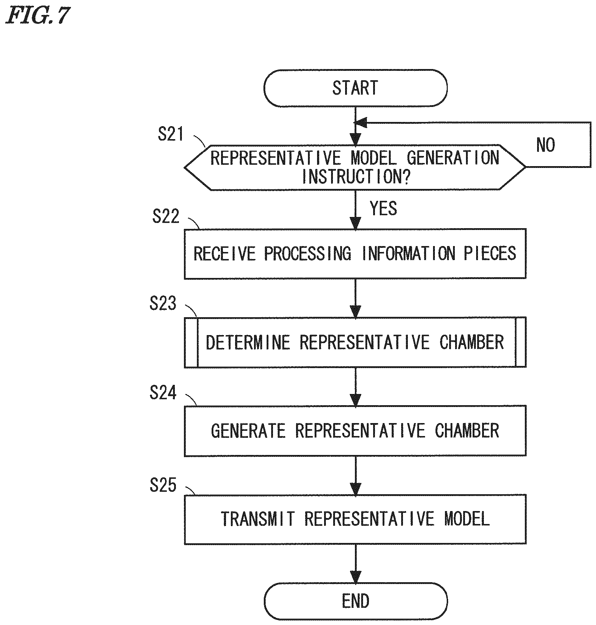

Fig. 7 is a flowchart showing one example of a flow of a model generation process. The model generation process is a process executed by the CPU included in the information analysis device 3 when the CPU executes a model generation program stored in the memory. With reference to Fig. 7, the CPU included in the information analysis device 3 determines whether a representative model generation instruction has been accepted (step S21). The process waits until the representative model generation instruction is accepted (NO in the step S21). If the representative model generation instruction is accepted (YES in the step S21), the process proceeds to the step S22.

In the step S22, the processing information pieces PI1 to Pln are received, and the process proceeds to the step S23. Transmission of the processing information pieces PI1 to Pln is requested to the assistance device 4, and the processing information pieces PI1 to Pln transmitted from the assistance device 4 are received. The processing information pieces PI1 to Pln are the processing information pieces collected by the assistance device 4 in a period during which the substrate processing apparatus 1 operates normally.

In the step S23, a representative chamber is determined, and the process proceeds to the step S24. A chamber selected by the administrator or the maintenance worker from among the plurality of chambers C1 to Cn is determined as the representative chamber.

In the step S24, the representative model is generated, and the process proceeds to the step S25. The processing information pieces Plrp corresponding to the representative chamber Crp determined in the step S23 are extracted from the processing information pieces PI1 to Pln received in the step S22. The processing information pieces Plrp are subjected to machine learning. Thus, the correlations in regard to the processing information pieces Plrp are learned, with each correlation representing the correlation between two different processing information pieces among the data pieces "a" to "i" included in the processing information pieces Plrp. Then, the representative model is generated. In the step S25, the representative model is transmitted to the assistance device 4, and the process ends.

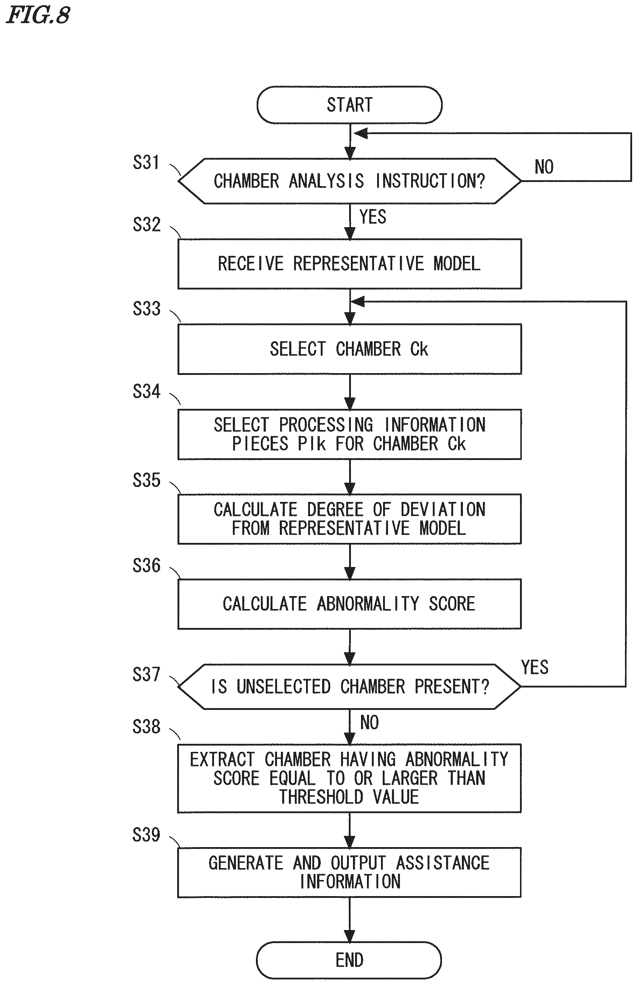

Fig. 8 is a flowchart showing one example of a process of comparing performance between chambers. An assistance information generation process is a process executed by the CPU included in the assistance device 4 when the CPU executes a program of comparing performance between chambers, with the program being stored in the memory.

With reference to Fig. 8, the CPU included in the assistance device 4 determines whether a chamber analysis instruction has been accepted (step S31). The process waits until the chamber analysis instruction is accepted (NO in the step S31). If the chamber analysis instruction is accepted (YES in the step S31), the process proceeds to the step S32.

In the step S32, a representative model is received, and the process proceeds to the step S33. Transmission of the representative model to the information analysis device 3 is requested, and the representative model transmitted from the information analysis device 3 is received.

In the step S33, a chamber Ck to be subjected to a process is selected from among the plurality of chambers C1 to Cn, and the process proceeds to the step S34. Here, k is an integer of 1 to n. In the step S34, the processing information pieces Plk corresponding to the chamber Ck that is selected as a chamber to be subjected to a process in the step S33 is selected from among the plurality of processing information pieces PI1 to PIn.

In the next step S35, the deviation degree between the chamber Ck selected as a chamber to be subjected to a process and the representative model is calculated. Specifically, in regard to each of the data pieces "a" to "i" included in the processing information pieces Plk corresponding to the chamber Ck selected as a chamber to be subjected to a process, the predicted value is obtained using the representative model, and the difference between the predicted value and each of the data pieces "a" to "i" is calculated as a deviation degree. In the next step S36, an abnormality score is calculated. In the step S35, the sum of the plurality of deviation degrees calculated in regard to the data pieces "a" to "i" included in the processing information pieces Plk is calculated as an abnormality score.

In the step S37, whether a chamber that is not selected as a chamber to be subjected to a process in the step S33 is present is determined. If an unselected chamber is present, the process returns to the step S33. If not, the process proceeds to the step S38.

In the step S38, a chamber having an abnormality score equal to or larger than a threshold value is extracted, and the process proceeds to the step S39. In the step S39, assistance information is generated to be output, and the process ends. The assistance information includes chamber identification information for identifying a chamber having an abnormality score equal to or larger than the threshold value, or a deviation-degree table. The deviation-degree table includes the deviation degrees respectively corresponding to the data pieces "a" to "i" included in the processing information pieces, with the deviation degrees calculated in the step S35 for the chamber having an abnormality score equal to or larger than the threshold value.

The maintenance worker who views the assistance information can find out the chamber that needs maintenance based on the chamber identification information included in the maintenance information. An abnormality score indicates a degree of difference between the chamber specified by the chamber identification information included in the maintenance information and the representative chamber in regard to an operation and a states for a process. An abnormality includes an abnormality that requires stopping of a substrate process and an abnormality that requires improvement although the process does not need to be stopped. The maintenance worker can specify a constituent element to be maintained by referring to the deviation-degree table included in the maintenance information.

### 6. First Modified Example

In the above-mentioned embodiment, the sum of the plurality of deviation degrees shown in the deviation-degree table shown in Fig. 4 is calculated as an abnormality score. In regard to the plurality of combinations for the data pieces "a" to "i" included in the processing information pieces shown in the deviation-degree table shown in Fig. 4, in a case in which the degree of abnormality of the substrate processing apparatus 1 is recognized, there may be a combination that needs to be particularly seriously considered and a combination that does not need to be seriously considered. In the first modified example, in a case in which a degree of abnormality of the substrate processing apparatus 1 is recognized, the combinations for the data pieces "a" to "i" included in the processing information pieces are weighted such that the larger a severity, the larger a weight. Then, the abnormality score is calculated. Specifically, a plurality of weighting tables corresponding to a plurality of combinations for a plurality of processing information pieces are used.

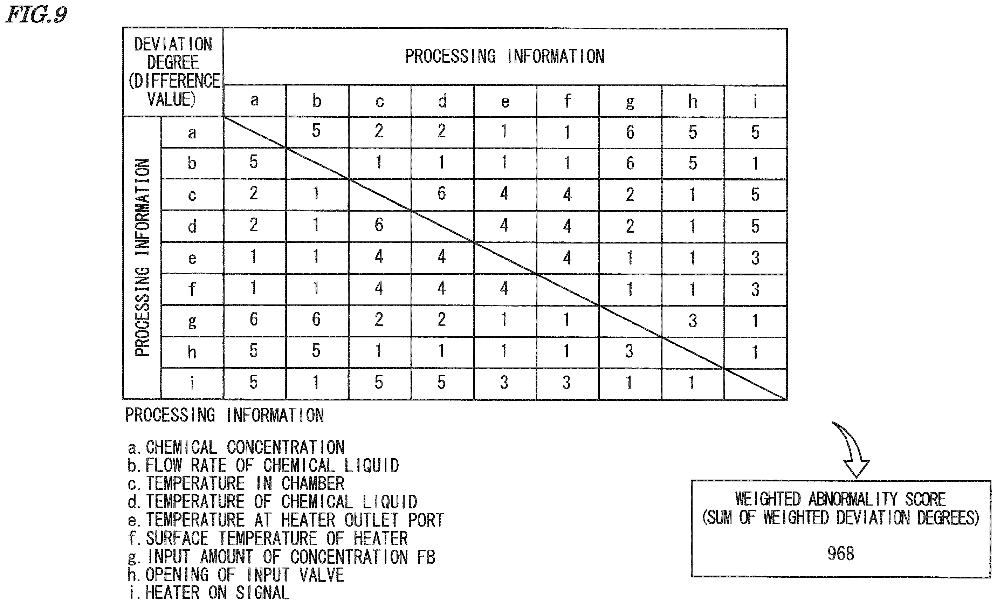

Fig. 9 is a diagram showing one example of a weighting table. In the weighting table, the weight having a magnitude corresponding to the relationship is assigned to each of the combinations for the data pieces "a" to "i" included in the processing information pieces in calculating the abnormality score.

For example, the combination of "a. CHEMICAL CONCENTRATION" and "g. INPUT AMOUNT OF CONCENTRATION FB" is considered to be extremely highly relevant to calculation of the abnormality score in order to detect the difference from the representative model. Therefore, a weight of "6" is assigned. Further, the combination of "a. CHEMICAL CONCENTRATION" and any one of "b. FLOW RATE OF CHEMICAL LIQUID," "h. OPENING OF INPUT VALVE" and "i. HEATER ON SIGNAL" is considered to be secondly highly relevant to calculation of the abnormality score in order to detect the difference from the representative model. Therefore, a weight of "5" is assigned. Further, the combination of "a. CHEMICAL CONCENTRATION" and any one of "b. TEMPERATURE IN CHAMBER" and "d. TEMPERATURE OF CHEMICAL LIQUID" is considered to be relevant, to some extent, to calculation of the abnormality score in order to detect the difference from the representative model. Therefore, a weight of "2" is assigned. Further, the combination of "a. CHEMICAL CONCENTRATION" and any one of "e. TEMPERATURE AT HEATER OUTLET PORT" and "d. SURFACE TEMPERATURE OF HEATER" is considered to be slightly relevant to calculation of the abnormality score in order to detect the difference from the representative model. Therefore, a weight of "1" is assigned.

In the first modified example, based on the weight assigned to each combination for the data pieces "a" to "i" included in the processing information pieces in the weighting table shown in Fig. 9, the deviation degree defined for each combination for the data pieces "a" to "i" included in the processing information pieces in the deviation-degree table shown in Fig. 4 is changed. Specifically, the deviation degree defined for each combination for the data pieces "a" to "i" included in the processing information pieces by the deviation-degree table shown in Fig. 4 is changed to the value (multiplication value) obtained when the deviation degree is multiplied by the weight assigned to each combination for the data pieces "a" to "i" included in the processing information pieces by the weighting table shown in Fig. 9. Then, the sum of the plurality of deviation degrees that have been changed in consideration of the weights is calculated as an abnormality score. Thus, the calculated abnormality score is 968.

In this manner, in the substrate processing apparatus management system 100 in the first modified example, the abnormality score is changed to a value obtained when the deviation degrees are weighted. Thus, the maintenance worker for the substrate processing apparatus 1 can appropriately recognize the degree of abnormality of each of the plurality of chambers C1 to Cn included in the substrate processing apparatus 1 by making reference to the abnormality score calculated based on the weighted deviation degrees.

### 7. Second Modified Example

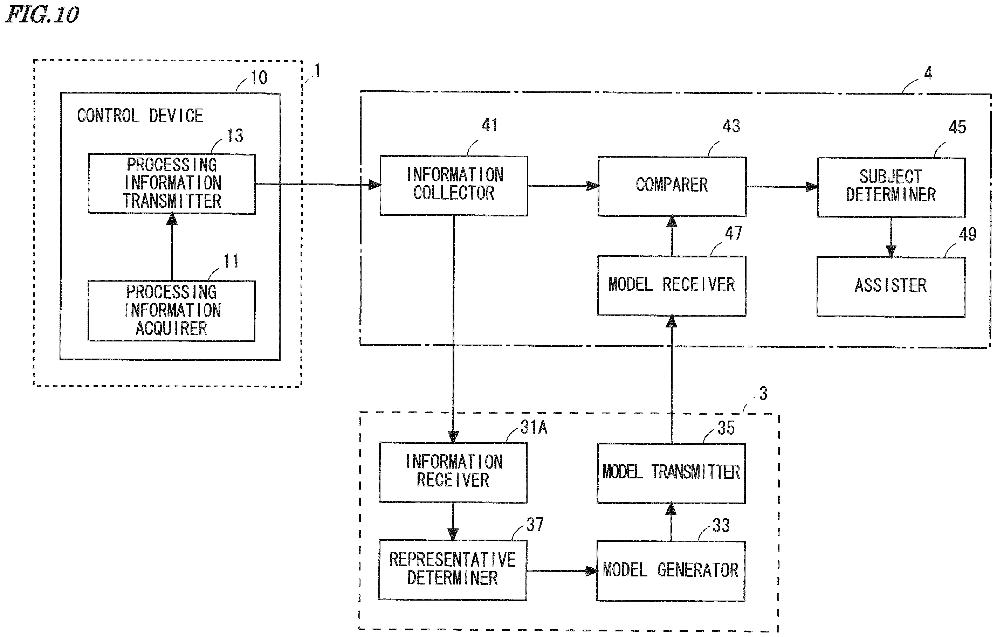

Fig. 10 is a block diagram for explaining one example of the functional configurations of the substrate processing apparatus management system in a second modified example. The substrate processing apparatus management system 100 in the second modified example automatically determines a representative model. With reference to Fig. 10, the diagram is different from the block diagram shown in Fig. 5 in that the representative information receiver 31 is changed to an information receiver 31A, and a representative determiner 37 is added. The other functional configurations are the same as those shown in Fig. 5. A description thereof will therefore not be repeated.

The information receiver 31A receives the processing information pieces PI1 to PIn respectively corresponding to the plurality of chambers C1 to Cn. The information receiver 31A outputs the processing information pieces PI1 to Pln to the representative determiner 37.

Based on the processing information pieces PI1 to PIn, the representative determiner 37 determines a representative chamber from among the plurality of chambers C1 to Cn. Specifically, based on the processing information pieces PI1 to PIn, the average value (average processing information piece) among the plurality of chambers C1 to Cn is calculated in regard to each of the data pieces "a" to i" included in the processing information pieces. By executing machine learning on the average of the data piece "a," and the average of the data piece "b" to the average of the data piece "i," the representative determiner 37 generates an average model that defines the correlation between the averages of two different data pieces forming each combination in regard to the average of the data piece "a," and the average of the data piece "b" to the average of the data piece "i."

Further, the representative determiner 37 determines a model closest to the average model from among the plurality of chambers C1 to Cn as a representative model. Specifically, the abnormality score is calculated based on each of the processing information pieces PI1 to Pin using the average model. For example, as for the processing information pieces PI1, in regard to each of the data pieces "a" to "i" included in the processing information pieces PI1, the representative determiner 37 calculates a predicted value using the average model, and the difference between each of the data pieces "a" to "i" and the predicted value is calculated as a deviation degree. The representative determiner 37 calculates the sum of the deviation degrees calculated for the plurality of combinations in regard to the data pieces "a" to "i" included in the processing information pieces as an abnormality score. The representative determiner 37 determines a chamber having the lowest abnormality score among the plurality of chambers C1 to Cn as a representative chamber.

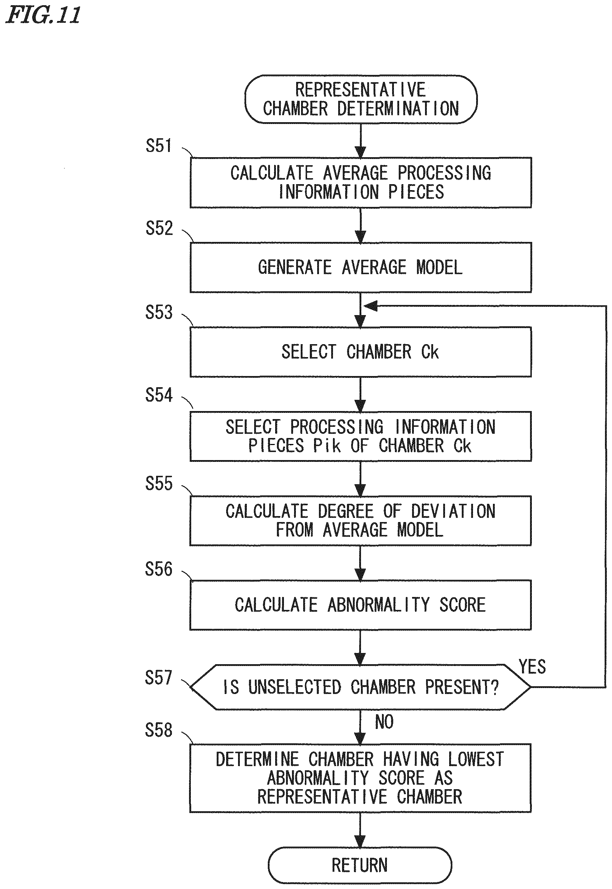

Fig. 11 is a flowchart showing one example of a flow of a representative chamber determination process. The representative chamber determination process is a process executed in the step S23 of the model generation process shown in Fig. 7 by the CPU included in the information analysis device 3 when the CPU executes the model generation program stored in the memory. With reference to Fig. 11, the CPU included in the information analysis device 3 calculates average processing information pieces based on the processing information pieces PI1 to Pin received in the step S22 (step S51), and the process proceeds to the step S52. The processing information pieces PI1 to Pin respectively include data pieces "a" to "i." The average processing information piece represents the average value, among the plurality of chambers c1 to Cn, that is calculated in regard to each of the data pieces "a" to "i."

In the step S52, machine learning is executed on the average processing information pieces, so that an average model is generated. Specifically, the correlation between two different average processing information pieces of the average processing information pieces is subjected to machine learning, and an average model is generated. In the step S53, a chamber Ck to be subjected to a process is selected from among the plurality of chambers C1 to Cn, and the process proceeds to the step S54. Here, k is an integer of 1 to n. In the step S54, from among the plurality of processing information pieces PI1 to Pln, processing information pieces Plk corresponding to the chamber Ck selected as a chamber to be subjected to a process in the step S53 is selected.

In the next step S55, the deviation degree between the chamber Ck selected as a chamber to be subjected to a process and the representative model is calculated. Specifically, in regard to each of the data pieces "a" to "i" included in the processing information pieces Plk corresponding to the chamber Ck selected as a chamber to be subjected to a process, the predicted value is obtained using the representative model, and the difference from the predicted value is calculated as a deviation degree. In the next step S56, an abnormality score is calculated. In the step S55, the sum of the deviation degrees calculated in regard to the respective data pieces "a" to "i" included in the processing information pieces Plk is calculated as the abnormality score.

In the step S57, whether a chamber that is not selected as a chamber to be subjected to a process in the step S53 is present is determined. If an unselected chamber is present, the process returns to the step S53. If not, the process proceeds to the step S58. In the step S58, the chamber having the lowest abnormality score is determined as the representative chamber, and the process returns to the representative model generation process.

In the substrate processing system in the second modified example, because a representative chamber is automatically determined, the administrator or the maintenance worker does not need to determine a representative chamber with reference to processing results. Therefore, it is possible to easily detect the difference between the chambers. In particular, a representative chamber can be determined at a stage where the processing results in regard to the processed substrates cannot be obtained or at a stage where the processing states after the maintenance work for the substrate processing apparatus 1 cannot be evaluated. Thereafter, at a stage where the processing results in regard to the processed substrates can be obtained, the administrator or the maintenance worker is simply required to select a representative chamber with reference to the processing results.

### 8. Third Modified Example

A substrate processing system in the third modified example executes a duplication process on a plurality of processing information pieces, and compares the correlations in regard to the plurality of processing information pieces in each of a plurality of chambers with the correlations in regard to a plurality of processing information pieces of a representative model. Further, the substrate processing system in the third modified example executes a logarithmic operation process on a plurality of processing information pieces to obtain the correlations in regard to the plurality of processing information pieces.

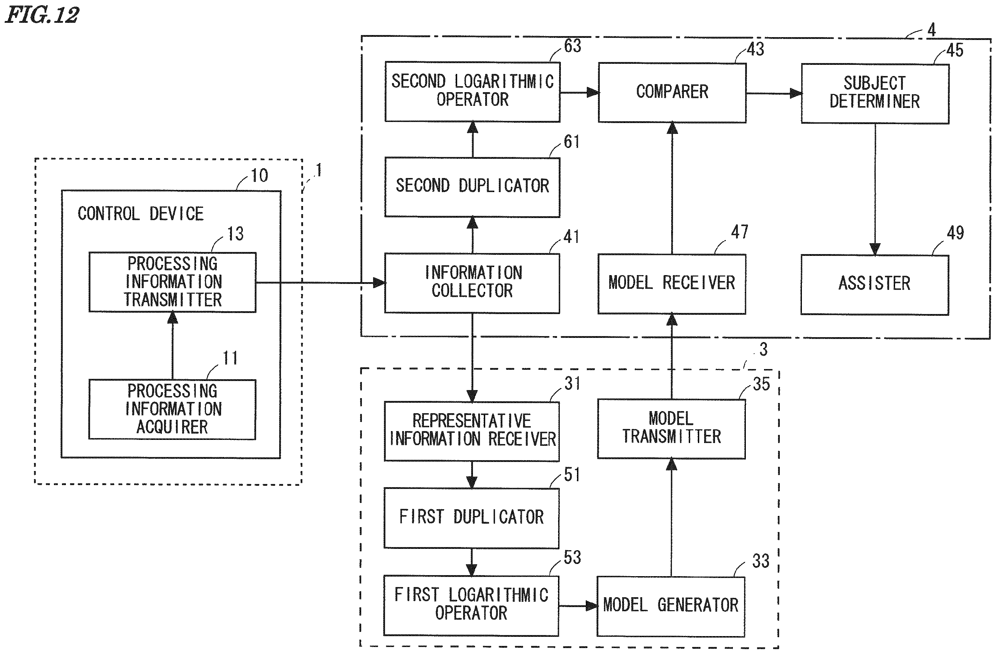

Fig. 12 is a block diagram for explaining one example of the functional configurations of the substrate processing apparatus management system in the third modified example. With reference to Fig. 12, the diagram is different from the block diagram shown in Fig. 5 in that a first duplicator 51 and a first logarithmic operator 53 are added to the information analysis device 3, and a second duplicator 61 and a second logarithmic operator 63 are added to the assistance device 4. The other functional configurations are the same as those shown in Fig. 5. A description thereof will therefore not be repeated.

The first duplicator 51 receives the processing information pieces Plrp corresponding to the representative chamber Crp from the representative information receiver 31. The first duplicator 51 executes a duplication process on the processing information pieces Plrp. The duplication process is a process of combining, with a plurality of processing information, a reference information piece predetermined for at least one subject processing information piece among the plurality of processing information pieces as a new processing information piece.

The first duplicator 51 classifies the plurality of processing information pieces Plrp corresponding to the representative chamber Crp received from the representative information receiver 31 into a subject group and a reference group. The reference group includes at least one of the plurality of processing information pieces Plrp. For example, one out of the plurality of processing information pieces Plrp received from the representative information receiver 31 may be classified into the reference group, or a plurality of information pieces out of the plurality of processing information pieces Plrp may be classified into the reference group. Among the plurality of processing information pieces Plrp received from the representative information receiver 31, the plurality of processing information pieces Plrp that have not been classified into the reference group are classified into the subject group.

The processing information pieces Plrp include the data pieces "a" to "i." The first duplicator 51 generates processing information pieces CPlrp in which at least one reference information piece that is out of the data pieces "a" to "i" included in the processing information pieces Plrp and is classified into the reference group is combined with the data pieces "a" to "i" included in the processing information pieces Plrp classified into the subject group as a new processing information piece.

One or more data pieces out of the data pieces "a" to "i" included in the processing information pieces Plrp are predetermined as a subject processing information piece to be subjected to the duplication process. Among the data pieces "a" to "i" included in the processing information pieces Plrp, a subject processing information piece preferably has no correlation or a slight correlation with any other processing information piece. Hereinafter, the data pieces included in the processing information pieces Plrp and classified into the reference group are referred to as data pieces "a"' to "i'."

In the present embodiment, all of the data pieces "a" to "i" included in the processing information pieces Plrp and classified into the subject group are subject processing information pieces to be subjected to the duplication process, by way of example. In this case, all of the data pieces "a"' to "i'" included in the processing information pieces Plrp classified into the reference group are reference information pieces. Therefore, processing information pieces CPlrp that are obtained when the duplication process is executed on the processing information pieces Plrp include 18 types of processing information pieces including the data piece "a", the data pieces "a"' to "i" and the data piece "i'."

The first logarithmic operator 53 receives the processing information pieces CPlrp obtained when the duplication process is executed from the first duplicator 51. The first logarithmic operator 53 outputs a plurality of logarithms obtained when the data piece "a," the data pieces "a'" to "i" and the data piece "i'" included in the processing information pieces CPlrp are logarithmically converted. Note that, instead of executing logarithmic conversion on all of the data piece "a," the data pieces "a'" to "i" and the data piece "i'" included in the processing information pieces CPlrp, logarithmic conversion may be executed on only a predetermined processing information piece among the data piece "a," the data pieces "a"' to "i" and the data piece "i'."

The model generator 33 generates a representative model by executing machine learning on the plurality of logarithms corresponding to the processing information pieces CPlrp received from the first logarithmic operator 53.

The second duplicator 61 receives the plurality of processing information pieces PI1 to Pin respectively corresponding to the plurality of chambers C1 to Cn from the information collector 41. The second duplicator 61 executes the duplication process on each of the processing information pieces PI1 to Pln. Because the same duplication process is executed on each of the processing information pieces PI1 to Pln, the duplication process for the processing information pieces PI1 will be described here.

The second duplicator 61 combines a reference information piece, which is predetermined for at least one subject processing information piece among the data pieces "a" to "i" included in the processing information pieces PI1, with the data pieces "a" to "i" as a new processing information piece. There is one or more subject processing information pieces that are predetermined as a processing information piece or processing information pieces that to be subjected to the duplication process among the data pieces "a" to "i" included in the processing information pieces PI1. A subject processing information piece is the same as a subject processing information piece that is defined at the time of generation of a representative model. Reference information pieces are the processing information pieces Plrp for the representative chamber Crp. Reference information pieces may be the processing information pieces Plrp for the representative chamber Crp, with the processing information pieces Plrp being classified into the reference group determined by the first duplicator 51, for example.

In the present embodiment, at the time of generation of the representative model, all of the data pieces "a" to "i" that are included in the processing information pieces Plrp and classified into the subject group are subject processing information pieces to be subjected to the duplication process. Therefore, the second duplicator 61 sets all of the data pieces "a" to "i" included in the processing information pieces PI1 as subject processing information pieces to be subjected to the duplication process. Further, the second duplicator 61 sets all of the data pieces "a"' to "i'" included in the processing information pieces Plrp of the representative chamber Crp as reference information pieces.

The second duplicator 61 generates processing information pieces CPI1 in which the data pieces "a"' to "i'" included in the processing information pieces Plrp are combined with the data pieces "a" to "i" included in the processing information pieces PI1. The processing information pieces CPI1 include 18 types of processing information pieces that are the data piece "a," the data piece "a"' to "i" and the data piece "i'."

The second logarithmic operator 63 receives the processing information pieces CPI1 obtained when the duplication process is executed from the second duplicator 61. The second logarithmic operator 63 outputs a plurality of logarithms obtained when the data piece "a," the data pieces "a"' to "i" and the data piece "i'" included in the processing information pieces CPI1 are logarithmically converted.

The comparer 43 compares the respective correlations in regard to the processing information pieces CPI1 to CPIn corresponding to the plurality of respective chambers C1 to Cn with the respective correlations for the representative model, and outputs the comparison results to the subject determiner 45. The processing information pieces CPI1 corresponding to the chamber C1 will be described, for example. The processing information pieces CPI1 include the data piece "a," the data pieces "a"' to "i" and the data piece "i'." In regard to each of a plurality of logarithms respectively corresponding to the data piece "a," the data pieces "a"' to "i" and the data piece "i'" included in the processing information pieces CPI1, the comparer 43 calculates, using the representative model, the predicted value for the logarithm and calculates the difference between the logarithm and the predicted value. Further, the comparer 43 calculates the sum of the plurality of deviation degrees calculated for the processing information pieces CPI1 as an abnormality score.

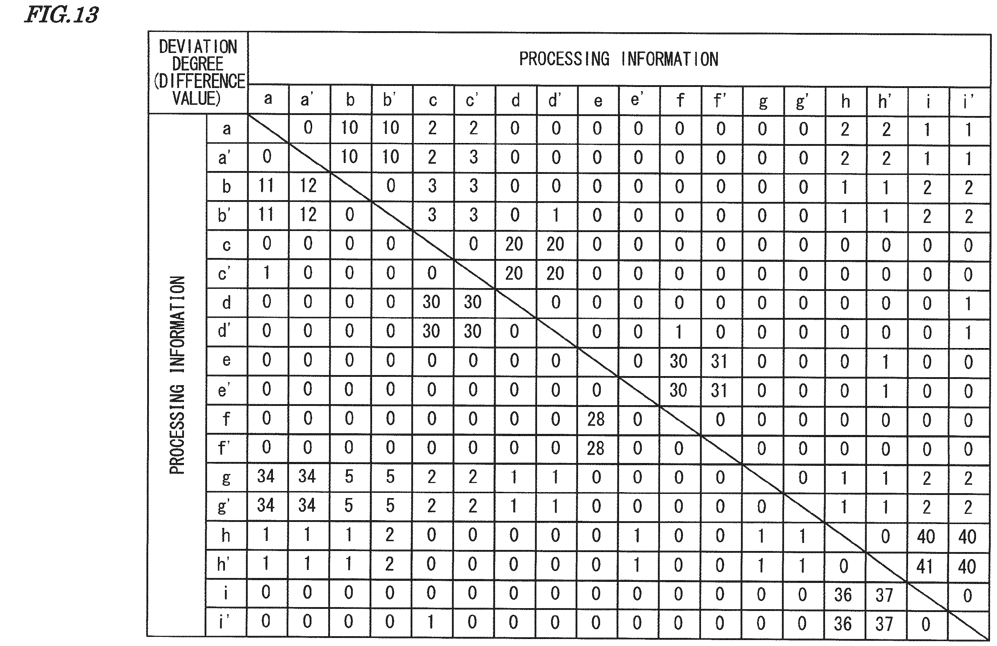

Fig. 13 is a diagram showing one example of a deviation-degree table in the third modified example. The deviation-degree table is the table representing the deviation degree for each of all combinations in regard to processing information pieces. The assistance device 4 calculates the above-mentioned deviation degrees for all combinations in regard to the processing information pieces. With reference to Fig. 13, each of the plurality of values arranged in the row at the right of each of the processing information piece "a," the processing information pieces "a"' to "i" and the processing information piece "i'" in the left column of the deviation-degree table represents the deviation degree between a processing information piece predicted based on each of the processing information piece "a," the processing information pieces "a"' to "i'" and the processing information piece "i'" in the upper row, and an actually acquired processing information piece. Each of the plurality of values arranged in the row below the processing information piece "a," the processing information pieces "a"' to "i" and the processing information piece "i'" in the upper row of the deviation-degree table represents the deviation degree between a processing information piece predicted based on each of the processing information piece "a," the processing information pieces "a"' to "i" and the processing information piece "i'" in the left column, and an actually acquired processing information piece.

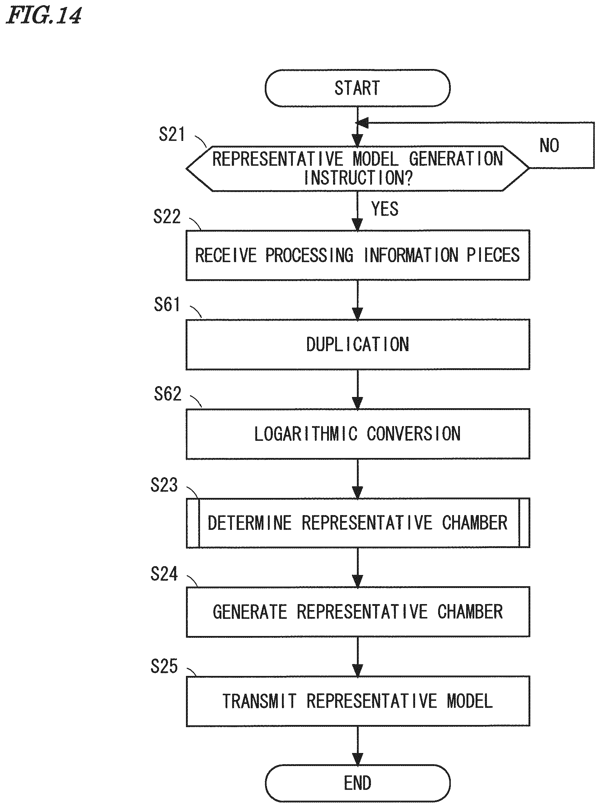

Fig. 14 is a flowchart showing one example of a flow of a model generation process in the third modified example. With reference to Fig. 14, the difference from the model generation process shown in Fig. 7 is that the step S61 and the step S62 are added between the step S22 and the step S23. The other processes are the same as the model generation process shown in Fig. 7. A description thereof will therefore not be repeated here.

In the step S61, the duplication process is executed, and the process proceeds to the step S62. The plurality of processing information pieces Plrp received in the step S22 are classified into a subject group and a reference group. Then, the data pieces "a"' to "i'" included in the processing information pieces Plrp and classified into the reference group as new processing information pieces are combined with the data pieces "a" to "i" included in the processing information piece Plrp and classified into the subject group.

In the step S62, the data piece "a," the data pieces "a"' to "i" and the data piece "i'" included in the processing information pieces CPlrp obtained when the duplication process is executed are logarithmically converted, and the process proceeds to the step S23. In the step S23, a representative chamber Crp is determined, and the process proceeds to the step S24.

In the step S24, a plurality of logarithms obtained when the processing information pieces CPlrp are logarithmically converted are subjected to machine learning, with the processing information pieces CPlrp being obtained when the duplication process is executed on the processing information pieces Plrp corresponding to the representative chamber Crp. In regard to the logarithm of each of the data piece "a," the data pieces "a"' to "i" and the data piece "i'" included in the processing information pieces CPlrp obtained when the duplication process is executed, the correlation between two different logarithms is learned, and a representative model is generated.

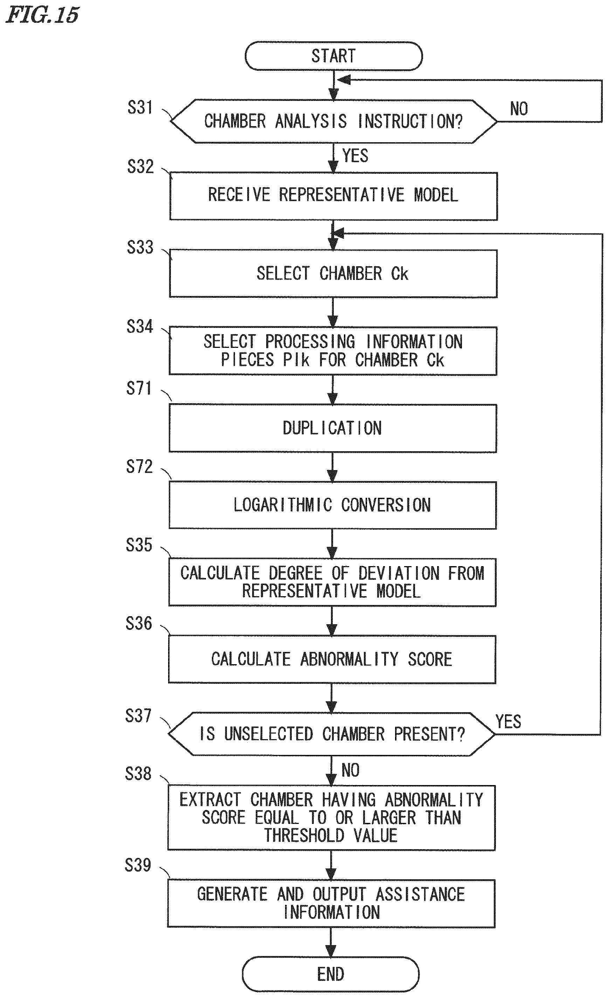

Fig. 15 is a flowchart showing one example of a flow of a process of comparing performance between chambers in the third modified example. With reference to Fig. 15, the difference from the process of comparing performance between chambers shown in Fig. 8 is that the step S71 and the step S72 are added between the step S34 and the step S35. The other processes are the same as the model generation process shown in Fig. 8. A description thereof will therefore not be repeated here.

In the step S71, a duplication process is executed, and the process proceeds to the step S72. The duplication process is executed on the processing information pieces Plk for the chamber Ck that are selected in the step S34. Reference information pieces are combined, as new processing information pieces, with the data pieces "a" to "i" included in the processing information pieces Plk. The reference information pieces are the data piece "a"' to "i'" included in the processing information pieces Plrp of the representative chamber Crp.

In the step S72, the data piece "a," the data pieces "a"' to "i" and the data piece "i'" included in the processing information pieces obtained when the duplication process is executed are logarithmically converted, and the process proceeds to the step S35. The processing information pieces CPlk obtained when the duplication process is executed on the processing information pieces Plk corresponding to the chamber Ck are logarithmically converted.

In the step S35, the degree of deviation between the chamber Ck selected as a chamber to be subjected to a process and the representative model is calculated. Specifically, in regard to each of the logarithms for the data piece "a," the data pieces "a"' to "i," the data piece "i'," and the data pieces "a" to "i" included in the processing information pieces CPlk obtained when the duplication process is executed on the processing information pieces Plk corresponding to the chamber CK selected as a chamber to be subjected to a process, the predicted value is obtained using the representative model, and the difference between the logarithm and the predicted value is calculated as a deviation degree.

### 9. Effects of Embodiments

With the assistance devices 4 according to the above-mentioned embodiments assist the maintenance work for the substrate processing apparatus 1 including the plurality of chambers C1 to Cn that process the substrates W. The assistance device 4 acquires the processing information pieces PI1 to Pin representing operations or states relating to a process for the substrate W in each of the plurality of chambers C1 to Cn, and generates the assistance information relating to the maintenance work for another chamber based on the comparison information obtained when the correlations in regard to the data pieces "a" to "i" included in the processing information pieces for the representative chamber Crp that is predetermined from among the plurality of chambers C1 to Cn are compared with the correlations in regard to the data pieces "a" to "i" included in the processing information pieces for another chamber. Because the representative chamber Crp and the other chamber are compared to each other about the correlations in regard to the data pieces "a" to "i" included in the processing information pieces, it is possible to detect a difference in operation or state relating to a process for the substrate W. Further, based on the comparison information obtained when the representative chamber and the other chamber are compared to each other about the correlations in regard to the data pieces "a" to "i" included in the processing information pieces, the assistance information relating to the maintenance work for the other chamber is generated. Thus, it is possible to generate information representing the differences between the performance of the other chamber and the performance of the representative chamber. As a result, it is possible to make notification of the assistance information representing the differences among the plurality of chambers C1 to Cn included in the substrate processing apparatus 1 in regard to performance.

Further, in regard to the adjustment of the plurality of chambers in a case in which the results of process for the substrate W in all of the plurality of chambers C1 to Cn are good, it is preferable that a chamber with poor performance is adjusted to have performance closer to the performance of a chamber with good performance. In the assistance device 4, a chamber with good performance is selected as the representative chamber Crp, so that the chamber identification information of a chamber with the performance poorer than that of the representative chamber and a deviation-degree table are generated as assistance information. Therefore, it is possible to generate assistance information for bringing the performance of a chamber with performance poorer than that of the representative chamber closer to the performance of the representative chamber.

Further, in regard to the assistance device 4 according to the first modified example, the comparison information is obtained when respective correlations in regard to the data pieces "a" to "i" included in processing information pieces are weighted and compared. Therefore, because the correlations in regard to the data pieces "a" to "i" included in the processing information pieces representing operations or states relating to a process for the substrate W are weighted, it is possible to detect the difference from the representative chamber Crp in regard to an operation or a state that has a great influence on the performance for the process for the substrate W.

Further, in the assistance device 4 according to the second modified example, one chamber having the correlations closest, among the plurality of chambers C1 to Cn, to the correlations in regard to the averages of the data pieces "a" to "i" included in the processing information pieces for the plurality of chambers C1 to Cn is determined as a representative chamber. Therefore, because the chamber the operation or the state of which is close to the average is determined as the representative chamber Crp from among the plurality of chambers C1 to Cn, with the operation or the state relating to a process for the substrate W, it is possible to automatically determine the representative chamber Crp. In particular, even when processing results obtained when the substrates W processed by the plurality of chambers C1 to Cn are inspected are not obtained, it is possible to determine the representative chamber Crp.

Further, each of the plurality of chambers C1 to Cn includes the chemical liquid valve 113a that discharges a chemical liquid and the flowmeter 124 that measures the flow rate of liquid discharged from the chemical liquid valve 113a. The data pieces "a" to "i" included in the processing information pieces include "h. OPENING OF INPUT VALVE" indicating an opening amount input to the discharge valve for control of an opening amount of the chemical liquid valve 113a and "b. FLOW RATE OF CHEMICAL LIQUID" indicating the flow rate measured by the flowmeter 124. Therefore, it is possible to generate the assistance information relating to the maintenance work for the chemical liquid valve 113a of another chamber based on the difference between the representative chamber Crp and the other chamber in regard to the correlation between "h. OPENING OF INPUT VALVE" and "b. FLOW RATE OF CHEMICAL LIQUID." The assistance information includes a deviation-degree table. The maintenance worker can determine whether "b. FLOW RATE OF CHEMICAL LIQUID" is stable by viewing the deviation-degree table, and determine an operation delay in regard to "h. OPENING OF INPUT VALVE."

Further, each of the plurality of chambers C1 to Cn includes the chemical liquid valve 113a that discharges a chemical liquid and the concentration meter 122 that measures the concentration of a chemical liquid, and the data pieces "a" to "i" included in the processing information pieces include "h. OPENING OF INPUT VALVE" indicating an opening amount input to the discharge valve for control of an opening amount of the chemical liquid valve 113a and "a. CHEMICAL CONCENTRATION" measured by the concentration meter 122. Therefore, it is possible to generate the assistance information relating to the maintenance work for another chamber based on the difference between the representative chamber Crp and the other chamber in regard to the correlation between "h. OPENING OF INPUT VALVE" and "a. CHEMICAL CONCENTRATION." The assistance information includes a deviation-degree table. The maintenance worker can determine whether "b. CHEMICAL CONCENTRATION" is stable by viewing the deviation-degree table, and can also determine an operation delay in regard to "h. OPENING OF INPUT VALVE."

Further, each of the plurality of chambers C1 to Cn includes the concentration meter 122 that measures the concentration of a chemical liquid and the first thermometer 123 that measures the temperature in a chamber, and the data pieces "a" to "i" included in the processing information pieces include "a. CHEMICAL CONCENTRATION" and "c. TEMPERATURE IN CHAMBER." Therefore, based on the difference between the representative chamber Crp and another chamber in regard to the correlation between a chemical concentration and a temperature in a chamber, it is possible to generate the assistance information relating to the maintenance work for the other chamber. The maintenance worker can determine whether "a. CHEMICAL CONCENTRATION" and "c. TEMPERATURE IN CHAMBER" are stable by viewing the deviation-degree table.

Further, each of the plurality of chambers C1 to Cn includes the concentration meter 122 that measures the concentration of a chemical liquid and the second thermometer 123a that measures the temperature of a chemical liquid. Further, the data pieces "a" to "i" included in the processing information pieces include "a. CHEMICAL CONCENTRATION" and "d. TEMPERATURE OF CHEMICAL LIQUID." Therefore, it is possible to generate the assistance information in regard to the maintenance work for another chamber based on the difference between the representative chamber Crp and the other chamber in regard to the correlation between the concentration of the chemical liquid and the temperature of the chemical liquid. The maintenance worker can determine whether "a. CHEMICAL CONCENTRATION" and "d. TEMPERATURE OF CHEMICAL LIQUID" are stable by viewing the deviation-degree table.

Further, the assistance device 4 acquires a deviation-degree table as comparison information. The deviation-degree table includes deviation degrees each of which indicates the degree of deviation between a predicted value that is predicted based on a processing information piece for another chamber using the correlations for the data pieces "a" to "i" included in the processing information pieces for the representative chamber Crp, and a processing information piece for another chamber. Therefore, because the predicted value for each of the data pieces "a" to "i" included in the processing information pieces for the other chamber is predicted using the correlations in regard to the data pieces "a" to "i" included in the processing information pieces for the representative chamber Crp, it is possible to compare the representative chamber Crp and the other chamber to each other about the correlations in regard to the data pieces "a" to "i" included in the processing information pieces. Because the deviation-degree table including the deviation degrees indicating respective degrees of deviation between a plurality of respective predicted values and the respective data pieces "a" to "i" included in the plurality of processing information pieces for other chambers is acquired as comparison information, it is possible to quantitatively represent the differences between the representative chamber Crp and another chamber about the correlations in regard to the data pieces "a" to "i" included in the processing information pieces.

In the third modified example, the representative model representing the correlations in regard to the plurality of processing information pieces for the representative chamber is generated, and the correlations in regard to the plurality of processing information pieces for each of the plurality of chambers are compared with the correlations in regard to the plurality of processing information pieces for the representative model. Therefore, it is possible to combine a processing information piece having no or slight correlation with another processing information piece with a reference information piece. Therefore, in regard to the processing information piece having no or slight correlation with another processing information piece, it is possible to provide the information relating to the difference from the representative chamber in regard to the performance.

Further, in the third modified example, after the logarithmic operation process is executed on at least one processing information piece among a plurality of processing information pieces, the correlations in regard to the plurality of processing information pieces are calculated. Therefore, it is possible to improve accuracy of correlation with another processing information piece in regard to a processing information piece having a small change.

### 10. Other Embodiments

(1) While the substrate processing apparatus 1 is a substrate cleaning device in the above-mentioned embodiment, the present invention is not limited to this. As long as including a plurality of chambers, the substrate processing apparatus 1 may be a single-wafer substrate cleaning device instead of a batch substrate cleaning device, or may have a configuration for executing a process other than a cleaning process. Further, the substrate processing apparatus 1 may be an apparatus that executes a wet edging process on the substrate W, or may be an apparatus that executes a Flash Lamp Anneal (FLA) process of heating the surface of the substrate using flash.
(2) In addition to or instead of the plurality of specific examples described in the above-mentioned embodiment, a plurality of processing information pieces may include another physical quantity. A physical quantity may include at least one of the number of rotations, a rotation speed and acceleration of a motor provided in a chamber, the flow rate of gas, a temperature, a humidity, and a pressure. Further, a plurality of processing information pieces may include an information piece relating to an output signal of a detector provided in a motor.
(3) While the assistance device 4 includes the assister 49 in the above-mentioned embodiment, the present invention is not limited to this. For example, the assistance information is transmitted from the assistance device 4 to the substrate processing apparatus 1, and the assistance information may be output in the form of being displayed on the substrate processing apparatus 1, for example. In this case, the maintenance worker can view the assistance information while maintaining the substrate processing apparatus 1.
(4) In the substrate processing apparatus management system 100 according to the above-mentioned embodiment, a series of processes executed by the information analysis device 3 may be executed by the assistance device 4. Further, the series of processes executed by the information analysis device 3 may be executed by the substrate processing apparatus 1. In this case, the information analysis device 3 is not required.
(5) While the substrate processing apparatus 1 and the assistance device 4 are provided separately in the above-mentioned embodiment, the substrate processing apparatus 1 and the assistance device 4 may be provided integrally. While the information analysis device 3 and the assistance device 4 are provided separately in the above-mentioned embodiment, the information analysis device 3 and the assistance device 4 may be provided integrally.
(6) While a representative model or an average model is generated based on invariant relationships in the assistance device 4 of the above-mentioned embodiment, the present invention is not limited to this. For example, in the assistance device 4, a representative model or an average model may be generated using another machine learning method such as deep learning.
(7) While the processing information pieces PI1 to Pln are transmitted from the processing information transmitter 13 of the substrate processing apparatus 1 to the information collector 41 of the assistance device 4 in the above-mentioned embodiment, the present invention is not limited to this. The processing information pieces PI1 to Pln may be provided through a cloud on the Internet, for example. In this case, the substrate processing apparatus 1 and the assistance device 4 do not need to directly communicate with each other, it is possible to reduce a communication load.
(8) While the assistance device 4 includes the model receiver 47 and the comparer 43 in the above-mentioned embodiment, the present invention is not limited to this. For example, the assistance device 4 may transmit each of the processing information pieces PI1 to Pln collected by the information collector 41 to the information analysis device 3, and may request the information analysis device 3 to calculate deviation degrees and an abnormality score. In this case, a deviation-degree table is generated by the information analysis device 3, and the deviation-degree table is transmitted to the assistance device 4.
(9) The first modified example may be combined with the third modified example.
(10) In the third modified example, the first duplicator 51 and the first logarithmic operator 53 are added to the information analysis device 3, and the second duplicator 61 and the second logarithmic operator 63 are added to the assistance device 4.

Instead, the first duplicator 51 may be added to the information analysis device 3, and the second duplicator 61 may be added to the assistance device 4. In this case, the first logarithmic operator 53 and the second logarithmic operator 63 are not required. The model generator 33 receives the processing information pieces CPlrp obtained when the duplication process is executed on the processing information pieces Plrp for the representative chamber Crp by the first duplicator 51, and the comparer 43 receives the processing information pieces CPlk obtained when the duplication process is executed on the processing information pieces Plk for the chamber Ck by the second duplicator 61. In this case, it is possible to combine a processing information piece that has no or slight correlation with another processing information piece with a reference information piece that has a correlation with another processing information piece. Therefore, in regard to the processing information piece having no or slight correlation with another processing information piece, it is possible to provide the information relating to the difference from the representative chamber in regard to their performance.

Further, the first duplicator 51 may be added to the information analysis device 3, the second duplicator 61 may be added to the assistance device 4, and the third modified example may be combined with the first modified example.

Further, the first logarithmic operator 53 is added to the information analysis device 3, and the second logarithmic operator 63 may be added to the assistance device 4. In this case, the first duplicator 51 and the second duplicator 61 are not required. The model generator 33 receives logarithms obtained when the first logarithmic operator 53 logarithmically converts the processing information pieces Plrp for the representative chamber Crp, and the comparer 43 receives logarithms obtained when the second logarithmic operator 63 logarithmically converts the processing information pieces PIk for the chamber Ck. In this case, it is possible to improve accuracy of the correlation with another processing information piece in regard to a processing information piece having a small change.

Further, the first logarithmic operator 53 may be added to the information analysis device 3, the second logarithmic operator 63 may be added to the assistance device 4, and the third modified example may be combined with the first modified example. Correspondences between Constituent Elements in Claims and Parts in Preferred Embodiments

### 11. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. In the above-mentioned embodiment, the information collector 41 is an example of a processing information collector, the assister 49 is an example of an assistance information generator, and the comparer 43 is an example of a deviation-degree acquirer. Further, the representative determiner 37 is an example of a representative chamber determiner. Further, the chemical liquid valve 113a is an example of a discharge valve, the flowmeter 127 is an example of a flow-rate measurer, the concentration meter 122 is an example of a concentration measurer, the first thermometer 123 is an example of a chamber-temperature measurer, and the second thermometer 123a is an example of a liquid-temperature measurer.

## Claims

1. A substrate processing apparatus management system including an assistance device that assists a maintenance work for a substrate processing apparatus including a plurality of chambers that process substrates, and an information analysis device, wherein
the information analysis device includes a model generator that generates a representative model representing correlations in regard to a plurality of processing information pieces, with each of the plurality of processing information pieces representing an operation or a state relating to a substrate process in a predetermined representative chamber among the plurality of chambers, and
the assistance device includes a processing information collector that acquires a plurality of processing information pieces for each of the plurality of chambers, and
an assistance information generator that, based on comparison information in which another chamber different from the representative chamber is compared with the representative chamber about correlations in regard to a plurality of processing information pieces, generates assistance information relating to a maintenance work for the another chamber.

2. An assistance device that assists a maintenance work for a substrate processing apparatus including a plurality of chambers that process substrates, comprising:
a processing information collector that acquires a plurality of processing information pieces representing operations or states relating to a substrate process in each of the plurality of chambers; and
an assistance information generator, based on comparison information in which correlations in regard to the plurality of processing information pieces for a predetermined representative chamber among the plurality of chambers are compared with correlations in regard to the plurality of processing information pieces for another chamber, generates assistance information about a maintenance work for the another chamber.

3. The assistance device according to claim 2, wherein
the comparison information is information obtained when respective correlations in regard to the plurality of processing information pieces are weighted and compared to one another.

4. The assistance device according to claim 2, wherein
the assistance information generator, after executing a duplication process of combining a reference information piece that is predetermined with respect to at least one subject processing information piece among the plurality of processing information pieces, as a new processing information piece, with the plurality of processing information pieces, calculates correlations in regard to a plurality of processing information pieces obtained when the duplication process is executed.

5. The assistance device according to claim 4, wherein
the comparison information is information obtained when respective correlations in regard to the plurality of processing information pieces are weighted and compared to one another.

6. The assistance device according to claim 2, wherein
the assistance information generator, after executing a logarithmic operation process on at least one subject processing information piece among the plurality of processing information pieces, calculates correlations in regard to the plurality of processing information pieces.

7. The assistance device according to claim 6, wherein
the comparison information is obtained when correlations in regard to the plurality of processing information pieces are weighted and compared to one another.

8. The assistance device according to claim 6, wherein
the assistance information generator, after executing a duplication process of combining a reference information piece that is predetermined with respect to at least one subject processing information piece among the plurality of processing information pieces, as a new processing information piece, with the plurality of processing information pieces, calculates correlations in regard to a plurality of processing information pieces obtained when the duplication process is executed.

9. The assistance device according to claim 8, wherein
the comparison information is obtained when correlations in regard to the plurality of processing information pieces are weighted and compared to one another.

10. The assistance device according to any one of claims 2 to 9, further comprising
a representative chamber determiner that determines one chamber having correlations closest to correlations in regard to averages of the plurality of processing information pieces for each of the plurality of chambers among the plurality of chambers as the representative chamber.

11. The assistance device according to any one of claims 2 to 9, wherein
each of the plurality of chambers includes a discharge valve that discharges liquid, and
a flow-rate measurer that measures a flow rate of liquid discharged from the discharge valve, and
each of the plurality of processing information pieces includes an open signal representing an opening amount input to the discharge valve for control of an opening amount of the discharge valve and a flow rate measured by the flow-rate measurer.

12. The assistance device according to any one of claims 2 to 9, wherein
each of the plurality of chambers includes
a discharge valve that discharges liquid, and
a concentration measurer that measures a concentration of liquid, and
each of the plurality of processing information pieces includes an open signal representing an opening amount input to the discharge valve for control of an opening amount of the discharge valve and a concentration measured by the concentration measurer.

13. The assistance device according to any one of claims 2 to 9, wherein
each of the plurality of chambers includes
a concentration measurer that measures a concentration of liquid, and
a chamber-temperature measurer that measures a temperature in a chamber, and each of the plurality of processing information pieces includes a concentration measured by the concentration measurer and a temperature measured by the chamber-temperature measurer.

14. The assistance device according to any one of claims 2 to 9, wherein
each of the plurality of chambers includes a concentration measurer that measures a concentration of liquid, and
a liquid-temperature measurer that measures a temperature of liquid, and
each of the plurality of processing information pieces includes a concentration measured by the concentration measurer and a temperature measured by the liquid-temperature measurer.

15. The assistance device according to any one of claims 2 to 9, further comprising a deviation-degree acquirer that acquires, as the comparison information, deviation-degree information representing respective degrees of deviation between a plurality of respective predicted values that are respectively predicted based on the plurality of processing information pieces for the another chamber using correlations in regard to the plurality of processing information pieces for the representative chamber, and the plurality of respective processing information pieces for the another chamber.

16. A substrate processing apparatus comprising the assistance device according to any one of claims 2 to 9.

17. A method of comparing performance between chambers, the method being executed by an assistance device that assists a maintenance work for a substrate processing apparatus including a plurality of chambers that process substrates, including the processes of:
acquiring a plurality of processing information pieces representing operations or states relating to a substrate process in each of the plurality of chambers; and
based on comparison information in which correlations in regard to a plurality of processing information pieces for a predetermined representative chamber among the plurality of chambers are compared with correlations in regard to a plurality of processing information pieces for another chamber, generating assistance information relating to a maintenance work for the another chamber.

18. A program of comparing performance between chambers, the program being executed by a computer included in an assistance device that assists a maintenance work for a substrate processing apparatus including a plurality of chambers that process substrates, and causing the computer to execute the processes of:
acquiring a plurality of processing information pieces representing operations or states relating to a substrate process in each of the plurality of chambers; and
based on comparison information in which correlations in regard to a plurality of processing information pieces for a predetermined representative chamber among the plurality of chambers are compared with correlations in regard to a plurality of processing information pieces for another chamber, generating assistance information relating to a maintenance work for the another chamber.
